(19) Europäisches Patentamt
European Patent Office
Office européen des brevets

(11) **EP 3 017 497 B1**

(12) **FASCICULE DE BREVET EUROPEEN**

(45) Date de publication et mention de la délivrance du brevet:
**17.05.2017  Bulletin 2017/20**

(21) Numéro de dépôt: **14736712.2**

(22) Date de dépôt: **01.07.2014**

(51) Int Cl.:
*H01M 10/44* *(2006.01)*        *H01M 10/0525* *(2010.01)*
*H02J 7/04* *(2006.01)*

(86) Numéro de dépôt international:
**PCT/EP2014/063926**

(87) Numéro de publication internationale:
**WO 2015/010860 (29.01.2015 Gazette 2015/04)**

(54) **MÉTHODE ET SYSTÈME DE GESTION DE LA CHARGE D'UNE BATTERIE RECHARGEABLE COMPRENANT PLUSIEURS BRANCHES D'ÉLÉMENTS ÉLECTROCHIMIQUES CONNECTES EN PARALLÈLE**

VERFAHREN UND SYSTEM ZUR VERWALTUNG DER LADUNG EINES AKKUS MIT MEHREREN ABZWEIGUNGEN VON PARALLEL GESCHALTETEN ELEKTROCHEMISCHEN ELEMENTEN

METHOD AND SYSTEM FOR MANAGING THE CHARGING OF A RECHARGEABLE BATTERY COMPRISING SEVERAL BRANCHES OF ELECTROCHEMICAL ELEMENTS CONNECTED IN PARALLEL

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **04.07.2013  FR 1356576**

(43) Date de publication de la demande:
**11.05.2016  Bulletin 2016/19**

(73) Titulaire: **SAFT**
**93170 Bagnolet (FR)**

(72) Inventeurs:
• **DESPREZ, Philippe**
**F-33200 Bordeaux (FR)**

• **ZENATI, Ali**
**Jacksonville, FL 32204 (US)**
• **BENJAMIN, Sébastien**
**F-33850 Leognan (FR)**
• **BARRAILH, Gérard**
**F-33170 Gradignan (FR)**

(74) Mandataire: **Hirsch & Associés**
**137, rue de l'Université**
**75007 Paris (FR)**

(56) Documents cités:
**US-A- 6 060 864        US-A- 6 121 752**
**US-B1- 7 573 233        US-B1- 7 573 234**

**Description**

DOMAINE TECHNIQUE

La présente invention concerne le domaine technique des méthodes de gestion de la charge d'une batterie rechargeable comprenant une pluralité de branches d'éléments électrochimiques connectés en parallèle. L'invention s'applique en particulier aux éléments électrochimiques présentant un profil de charge comprenant au moins une zone dans laquelle la tension ne varie pas de manière continûment proportionnelle avec l'état de charge.

L'invention concerne également les systèmes électroniques permettant de mettre en oeuvre le procédé de gestion de la charge de ce type de batterie.

ETAT DE LA TECHNIQUE

Un générateur électrochimique ou accumulateur (encore désigné par le terme « élément »), est un dispositif de production d'électricité dans lequel de l'énergie chimique est convertie en énergie électrique. L'énergie chimique est constituée par des composés électrochimiquement actifs déposés sur au moins une face d'électrodes disposées dans l'élément. L'énergie électrique est produite par des réactions électrochimiques au cours d'une décharge de l'élément. Les électrodes, disposées dans un conteneur, sont connectées électriquement à des bornes de sortie de courant qui assurent une continuité électrique entre les électrodes et un consommateur électrique auquel l'élément est associé.

Typiquement une batterie comprend une pluralité d'éléments susceptibles d'être regroupés au sein d'une même enceinte. Une batterie peut être divisée en modules, chaque module étant composé d'une pluralité d'éléments reliés entre eux en série et/ou en parallèle. La batterie est destinée à fournir de l'énergie électrique à une application extérieure. Un circuit de charge est généralement prévu auquel la batterie peut être branchée pour recharger les éléments. Un système de gestion comprenant des capteurs de mesures et un circuit électronique de contrôle, plus ou moins évolué selon les applications, peut être associé à la batterie.

Il est connu des documents EP-A-2 144 075, EP-A-2 239 826 et EP-A-2 309 615, relatifs à des batteries de type Lithium-ion, d'utiliser comme matériau d'électrode positive d'un élément des phosphates lithiés d'au moins un métal de transition, notamment les composés de type $LiMPO_4$ où M est choisi dans le groupe comprenant Fe, Co, Ni, Mn et un mélange de ceux-ci. Ces phosphates lithiés présentant une meilleure stabilité thermique que les oxydes lithiés de métaux de transition de type $LiM^1O_2$ classiquement utilisés dans les éléments au lithium, où $M^1$ représente au moins un élément de transition choisi généralement parmi Co, Ni et Mn. L'utilisation de phosphates lithiés permet donc de réduire le risque de réactions violentes dans le cas où l'accumulateur est placé dans des conditions de surcharge.

Il est aussi connu d'utiliser comme matière active un mélange comprenant $LiMPO_4$ et un composé de type $LiM^1O_2$ où $M^1$ représente au moins un élément de transition choisi généralement parmi Co, Ni, Fe, Mn et Al. En particulier, le document EP-A-2 269 954 divulgue une matière électrochimiquement active qui est un mélange, désigné par la suite « type NCA/LFP », comprenant :

a) moins de 10% en poids d'un oxyde lithié comprenant de l'aluminium et des métaux de transition contenant au moins du nickel et du cobalt ; et

b) au moins 90% en poids un phosphate lithié d'au moins un métal de transition, dont la surface est recouverte au moins partiellement d'une couche de carbone. Ce type de matière active présente un bon compromis entre capacité élevée et stabilité thermique.

Dans des éléments dont l'électrode positive comprend une matière électrochimiquement active de type phosphate lithié ou du type de celle décrite dans le document EP-A-2 269 954, la tension de l'élément varie très faiblement en fonction de son état de charge pour un état de charge compris entre environ 30 et environ 90%.

On rappelle que l'état de charge (SOC « state of charge » en anglais) est déterminé comme la quantité d'énergie disponible dans la batterie rapportée à l'énergie d'une batterie totalement chargée. Il s'exprime en pourcentage et reflète la part d'énergie restante disponible pour l'utilisateur. Dans ce type d'élément, comprenant au moins une matière électrochimiquement active de type phosphate lithié la variation de la tension à vide en fonction de l'état de charge présente une zone pour un état de charge compris entre environ 30 et environ 90% dans laquelle la tension à vide augmente au moins 10 fois moins rapidement en fonction de l'état de charge en moyenne que pour un état de charge compris entre 90% et 100%.

On entend par tension à vide la tension mesurée aux bornes de l'élément lorsque celui-ci ne débite aucun courant (« Open Circuit Voltage » (OCV) en anglais et également dénommé « tension en circuit ouvert » ; selon la *définition 482-03-32 de la norme CEI 60050-482:2004, Vocabulaire électrotechnique international partie 482 : piles et accumulateurs électriques*).

On entend par variation de la tension en fonction de l'état de charge, soit la dérivée de la tension par rapport à l'état de charge, soit le rapport $\dfrac{\Delta V}{\Delta SOC} = \dfrac{V_2 - V_1}{SOC_2 - SOC_1}$ où :

- $V_1$ et $V_2$ représentent les valeurs de tensions de deux points situés sur la courbe de la tension en fonction de l'état de charge, et
- $SOC_1$ et $SOC_2$ représentent les états de charge correspondant aux valeurs de tension $V_1$ et $V_2$.

Par exemple, un élément dont l'électrode positive comprend une matière électrochimiquement active de type lithium phosphate de fer $LiFePO_4$ avec 10% de NCA chargée à un courant de C/5 Ampère a une tension qui augmente d'environ 0,5 millivolt par minute pour un état de charge compris entre 30 et 90% et augmente d'environ de 20 millivolts par minute pour un état de charge compris entre 90% et 100%, C étant la capacité nominale de l'élément. En raison de cette très faible variation de tension, il est difficile d'estimer avec précision l'état de charge de l'élément en fonction de sa tension lorsque l'état de charge est compris entre environ 30 et 90%.

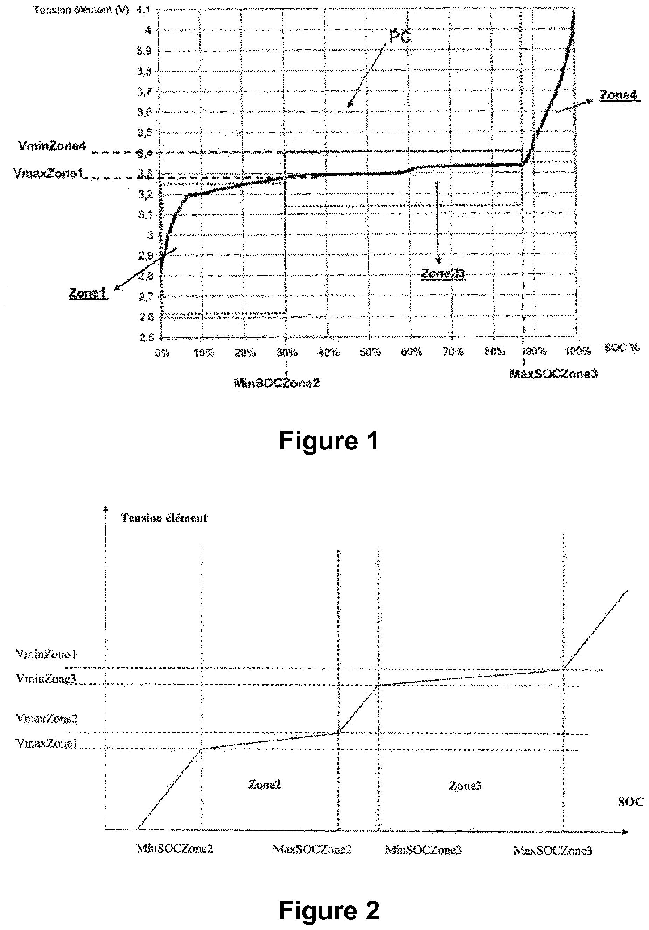

La Figure 1 représente schématiquement le profil de charge (PC) d'un élément dont l'électrode positive comprend une matière électrochimiquement active de type de celle décrite dans le document EP-A-2 269 954. Les trois zones principales sont représentées :

**Zone 1:** elle correspond à une tension inférieure ou égale à VmaxZone1. A la valeur VmaxZone1 correspond un état de charge égal à MinSOCZone2. VmaxZone1 se situe en général entre 3 et 3,30 V et vaut typiquement 3,25 V. MinSOCZone2 se situe généralement dans la gamme allant de 15 à 30 %, typiquement 30 %. Dans la zone 1, la tension varie quasiment proportionnellement avec l'état de charge ; c'est-à-dire qu'à une tension donnée de l'élément correspond un état de charge donné. La zone 1 se subdivise encore en une première zone d'état de charge comprise entre 0 et moins de 10 %, dans laquelle la tension de l'élément varie de plus 300 mV et une seconde zone d'état de charge comprise entre typiquement 10 % et typiquement 30 %, dans laquelle la tension varie moins vite en fonction de l'état de charge, par exemple d'environ 100 mV pour un accroissement d'état de charge de 20 %.

**Zone 23:** elle correspond à une tension supérieure à VmaxZone1 et inférieure à VminZone4. VminZone4 se situe en général entre 3,35 et 3,45 V, et vaut typiquement 3,35 V. A la valeur VminZone4 correspond un état de charge égal à MaxSOCZone3. MaxSOCZone3 se situe généralement dans la gamme allant de 80 à 95 %, typiquement 90%. La zone 23 correspond typiquement à la zone de tensions comprises entre 3,25 V et 3,35 V correspondant à un état de charge compris typiquement entre 30 % et typiquement 90 %. On peut noter une variation de tension de l'élément quasi nulle pour un état de charge compris entre 30 % et 60 % et pour un état de charge compris entre 65 % et 90 %. Dans la zone 23, la tension de l'élément varie peu, typiquement de l'ordre de 100 mV pour un état de charge compris entre environ 30 et environ 90 %. Il en résulte une forte imprécision sur la mesure de l'état de charge dans la zone 23 puisqu'une valeur donnée de tension peut correspondre à un état de charge compris dans une large plage allant de 30 à 90 %. La zone 23 se subdivise en deux sous-zones comme le montre la figure 2 qui est un agrandissement de la figure 1: une première sous-zone : la zone 2 allant de MinSOCZone2 à MaxSOCZone2, soit de 30 à 60% et une seconde sous-zone, la zone 3 allant de MinSOCZone3 à MaxSOCZone3, soit de 65 à 90%. Les zones 2 et 3 se rejoignent vers un état de charge compris entre 60 et 65%.

**Zone 4:** elle correspond à une tension supérieure ou égale à VminZone4. A la valeur VminZone4 correspond un état de charge égal à MaxSOCZone3. VminZone4 correspond à un état de charge d'environ 90%. Dans cette zone, la tension varie proportionnellement avec l'état de charge. Elle varie d'environ au moins 300 mV. A une tension donnée de l'élément correspond un état de charge donné.

Ce profil de charge est commun aux composés de type $LiMPO_4$ où M est choisi dans le groupe comprenant Fe, Co, Ni, Mn et un mélange de ceux-ci.

Dans la zone 1, la variation de la tension de l'élément en fonction de l'état de charge pour un état de charge inférieur à MinSOCzone2 correspondant à une tension Vmaxzone1 est en moyenne au moins 2 fois plus rapide que la variation de la tension pour un état de charge compris entre MinSOCZone2 et MaxSOCZone3.

Il est connu du document US 7 940 027 B un procédé pour gérer la charge d'une batterie rechargeable comprenant des éléments électrochimiques connectés en série et formant une branche. Chaque élément électrochimique a un courant de charge continue maximal prédéterminé IMR_C autorisé pour des conditions données de température et d'état de charge. Chaque branche comprend un capteur de courant permettant de mesurer le courant circulant dans les éléments électrochimiques de la branche et un calculateur qui met à jour en permanence les courants maximums autorisés en charge impulsionnelle (IMR) et continue (IMR_C) selon le procédé du brevet US 7 940 027 B. Un superviseur batterie collecte les mesures du courant traversant chacune des branches ainsi que les courants maximums autorisés en charge impulsionnelle (IMR) et en continue (IMR_C) de chacune des branches. Ce superviseur fournit une consigne de courant par impulsions et continu au chargeur afin que le courant traversant chaque branche respecte (selon une régulation de type Proportionnel Intégral) ces courants maximums autorisés en charge pulse (IMR) et continue (IMR_C).

Dans certaines applications nécessitant une importante capacité de stockage d'énergie de nombreux éléments électrochimiques doivent être connectés en parallèle afin d'augmenter la capacité de la batterie. Avec la solution proposée dans le brevet US 7 940 027 B, la taille du dispositif devient très importante à cause de tous les calculateurs nécessaires à la supervision de chacune des branches et du câblage associé pour amener au calculateur toutes les mesures de tension des éléments. De ce fait un volume important est perdu et un poids supplémentaire diminue également les performances du système si l'on regarde l'énergie volumique ou massique.

Pour tout couple électrochimique, par exemple de type lithium-ion avec des éléments branchés directement en parallèle, il y a des risques d'avoir des courants différents entre les branches notamment en charge aboutissant à un vieillissement prématuré de la batterie. La cause de cette différence de courant peut différer selon la matière active (NCA/NMC avec N pour le Nickel, C pour le Cobalt, A pour l'Aluminium et M pour le Manganèse ou du type LFP avec L pour Lithium, F pour Fer et P pour Phosphate) de l'électrode positive.

En effet, pour des couples électrochimiques présentant une évolution de la tension à vide en fonction de la SOC pentue (comme par exemple lithium-on avec matériau cathodique de type NCA/NMC) les déséquilibres éventuels d'état de charge entre des éléments connectés en parallèle vont pouvoir se rééquilibrer au fur et à mesure de la charge, de la décharge et lors des phases de repos. Cependant un courant de charge supérieur au courant autorisé pour le vieillissement nominal peut apparaître du fait des dispersions de résistance des éléments, incluant les connexions et les barres de connexion de puissance (« bus bar » en anglais).

Pour des couples électrochimiques présentant une évolution de la tension à vide en fonction de la SOC très faible avec un plateau important avant la fin de charge (comme par exemple du phosphate de fer LFP ou un mélange NCA/LFP), ou plusieurs plateaux (comme le LFMP avec L pour Lithium, F pour Fer, M pour Manganèse et P pour Phosphate), il peut également y avoir des courants de charge supérieur au courant autorisé pour le vieillissement nominal du fait des dispersions de résistance des éléments, incluant les connections et les bus bar à état de charge identique entre éléments.

Néanmoins, les déséquilibres éventuels d'état de charge entre éléments connectés en parallèle ne vont pas pouvoir se rééquilibrer au fur et à mesure de la charge et ainsi lorsqu'un élément arrive en fin de charge, c'est-à-dire dans la zone pentue, avant les autres, les autres éléments vont alors devoir absorber le courant de charge qui traversait jusqu'alors cet élément. L'écart initial d'état de charge provient d'autodécharges différentes, de résistances différentes ou de capacités différentes lors d'une décharge complète qui réalise un équilibrage « par le bas ». Au fur et à mesure que les éléments vont atteindre cette zone pentue le dernier élément se trouvant sur le plateau va finalement se voir traverser par une partie très importante du courant de la batterie.

Or un courant trop important en charge et en particulier en fin de charge, c'est-à-dire au moment où l'acceptation de courant en charge est plus faible, peut faire vieillir très rapidement l'élément par dépôt de lithium sur l'électrode négative en diminuant la capacité et/ou en augmentant la résistance de l'élément. Un tel problème de vieillissement prématuré est surtout connu pour les batteries alcalines.

Il est de plus connu du document US6121752 un procédé de gestion de la charge d'une batterie rechargeable par un contrôle en tension ou par un contrôle en intensité comprenant une pluralité de branches connectées en série, chaque branche comportant une pluralité d'éléments électrochimiques connectés en parallèle, le dit procédé comprenant les étapes suivantes :

a) fournir des données caractéristiques des éléments électrochimiques, les données caractéristiques comprenant au moins une tension de charge de référence
e) mesure en temps réel de la tension aux bornes de chaque branche d'éléments électrochimiques connectés en parallèle;
f) mesure en temps réel de la température de la batterie rechargeable;
g) évaluation en temps réel d'une tension de contrôle égale à la tension de charge divisée par le nombre de branches;et dans le cas d'un contrôle en tension
f) transmission en temps réel à un régulateur de chargeur intégré dans la batterie de la valeur de la tension de contrôle évaluée de manière à alimenter les éléments électrochimiques de la batterie.

Il n'existe actuellement pas de méthode susceptible d'être adaptée de manière satisfaisante à la gestion de la charge d'une batterie rechargeable comportant des branches d'éléments électrochimiques connectés en parallèle, en particulier pour des éléments électrochimiques de type lithium-ion.

Il existe donc un besoin pour un système et un procédé de gestion de la charge permettant de charger des telles batteries sans risque de vieillissement trop rapide des éléments électrochimiques. En particulier pour des éléments électrochimiques présentant un large plateau avant la fin de charge sur leur caractéristique tension à vide en fonction de l'état de charge, il existe un besoin de charger selon un profil de courant permettant de respecter les préconisations de courant de charge du fabriquant d'éléments garantissant une durée de vie nominale de la batterie.

Les préconisations des courants de charge maximum autorisés des batteries peuvent s'exprimer en un courant maximum continu (IMR_C) mais également pour des sollicitations plus courtes par un courant maximum impulsionnel de charge (IMR) pour une durée de pulse donnée ou suivant un algorithme.

RESUME DE L'INVENTION

A cet effet, la présente invention propose un procédé de gestion de la charge d'une batterie rechargeable comprenant une pluralité (p) d'éléments électrochimiques connectés en parallèle. Chaque élément électrochimique comprend une électrode comportant une matière active présentant un profil de charge (PC) comportant au moins une zone plateau directement suivie par une zone pentue dans lequel la variation de la tension en fonction de l'état de charge dans la zone plateau est en moyenne au moins 10 fois moins rapide que la variation de la tension dans la zone pentue. Ce procédé s'applique à la gestion de la charge d'une batterie d'éléments électrochimiques de type Lithium-ion.

L'invention vise donc un procédé de gestion de la charge d'une batterie rechargeable par un contrôle en tension ou par un contrôle en intensité comprenant une pluralité (n) de branches connectées en série, chaque branche comportant une pluralité (p) d'éléments électrochimiques connectés en parallèle, chaque élément électrochimique présentant un profil de charge (PC) comportant au moins une zone plateau directement suivie par une zone pentue dans lequel la variation de la tension en fonction de l'état de charge dans la zone plateau est en moyenne au moins 10 fois moins rapide que la variation de la tension dans la zone pentue, le dit procédé comprenant les étapes suivantes :

a) fournir des données caractéristiques des éléments électrochimiques, les données caractéristiques comprenant au moins :

- une fonction prédéterminée représentant la variation de la valeur de la résistance interne (Rcell) d'un élément électrochimique de la batterie en fonction de la température (T),
- une valeur de courant de charge maximal prédéterminé pour un élément (IMR, IMR_C) autorisé en fonction de la température (T), et
- la valeur moyenne de la tension dans la zone plateau (E0_plateau),

b) mesure en temps réel de la tension (Vcell_n) aux bornes de chaque branche d'éléments électrochimiques connectés en parallèle ;
c) mesure en temps réel de la température (T) de la batterie rechargeable ;
d) évaluation en temps réel d'une tension de contrôle (Vcontrol) égale à la somme de la valeur moyenne de la tension dans la zone plateau (E0_plateau) et du produit de la valeur de la résistance interne (Rcell) d'un élément électrochimique par la valeur du courant de charge maximal prédéterminé (IMR, IMR_C) autorisé en fonction de la température (T) mesurée ;

et dans le cas d'un contrôle en intensité :

e1) évaluation en temps réel de la tension maximale (Vmax) des éléments électrochimiques de la batterie définie comme étant le maximum des tensions mesurées (Vcell_n) aux bornes de chaque branche ;
e2) évaluation en temps réel d'un courant maximal seuil instantané de charge traversant les éléments électrochimiques connectés en parallèle en fonction de la tension de contrôle évaluée (Vcontrol) en régulant le courant maximal seuil instantané de charge de sorte que la tension maximale (Vmax) des éléments électrochimiques soit égale à la tension de contrôle évaluée (Vcontrol) ;
e3) détermination en temps réel d'un courant maximal instantané de charge (IMR_parallel ou IMR_C_parallel) à appliquer aux éléments électrochimiques, dans lequel le courant maximal instantané de charge est égal au minimum entre le courant maximal seuil instantané de charge évalué et le produit entre le nombre (p) d'éléments électrochimiques par branche et le courant de charge maximal prédéterminé (IMR, IMR_C) autorisé ; et
e4) transmission en temps réel à un régulateur de chargeur intégré dans la batterie de la valeur du courant maximal instantané de charge (IMR_parallel ou IMR_C_parallel) déterminée de manière à alimenter les éléments électrochimiques de la batterie avec une intensité inférieure ou égale au maximum de courant maximal instantané de charge déterminé ;

et dans le cas d'un contrôle en tension :

f) transmission en temps réel à un régulateur de chargeur intégré dans la batterie de la valeur de la tension de contrôle (Vcontrol) évaluée de manière à alimenter les éléments électrochimiques de la batterie.

Le procédé permet de réguler le courant de charge d'une batterie composée d'éléments connectés directement en parallèle afin de garantir un vieillissement identique au vieillissement d'un élément dont le courant de charge respecte le courant maximum prescrit pour cet élément (appelés IMR ou IMR_C). Dans cette configuration, la seule mesure disponible par branche d'éléments connectés en parallèle est la mesure de tension puisque il n'y a pas un capteur de courant par élément. L'invention utilise cette tension, et en particulier la tension maximale de ces tensions, pour garantir le courant maximum traversant chaque élément, en fournissant au chargeur, selon son type soit une consigne de tension soit une consigne en courant.

Le procédé de gestion de la charge de la batterie est utilisable que les éléments électrochimiques soient adaptés à être chargés de manière continue ou pulsée.

Selon un mode de réalisation du procédé précédent, on substitue l'étape de fourniture des données caractéristiques des éléments électrochimiques par une autre étape de fourniture de données caractéristiques des éléments électrochimiques comprenant au moins :

- une fonction prédéterminée représentant la variation de la valeur de la résistance interne (Rcell) d'un élément électrochimique de la batterie en fonction de la température (T) et de l'état de charge de chaque élément électrochimique (SOC) et/ou de l'état de vieillissement de chaque élément électrochimique (SOH),
- une valeur de courant de charge maximal prédéterminé (IMR, IMR_C) autorisé en fonction de la température (T) et de l'état de charge de chaque élément électrochimique (SOC) et/ou de l'état de vieillissement de chaque élément électrochimique (SOH), et
- la valeur de la tension dans la zone plateau (E0) en fonction de la température (T) et de l'état de charge de chaque élément électrochimique (SOC) et/ou de l'état de vieillissement de chaque élément électrochimique (SOH) ; et

dans lequel on substitue l'étape d'évaluation en temps réel de la tension de contrôle (Vcontrol) par une autre étape d'évaluation en temps réel de la tension de contrôle (Vcontrol) égale à la somme de la valeur moyenne de la tension dans la zone plateau (E0) et du produit de la valeur de la résistance interne (Rcell) d'un élément électrochimique par la valeur du courant de charge maximal prédéterminé (IMR, IMR_C) autorisé en fonction de la température (T) mesurée, et de l'état de charge de chaque élément électrochimique (SOC) mesuré et/ou de l'état de vieillissement de chaque élément électrochimique (SOH) mesuré.

Ce mode de réalisation permet de prendre en compte pour la gestion de la charge de la batterie d'autres paramètres que la température tels que l'état de charge (SOC) et/ou l'état de vieillissement (SOH) des différents éléments électrochimiques permettant d'améliorer la gestion de la charge de la batterie en chargeant chaque élément électrochimique de façon optimale.

En effet, la valeur de la tension caractéristique de la zone plate E0 peut dépendre de l'état de charge de la batterie (SOC), voire de la température et/ou de l'état de vieillissement de la batterie. De même, la résistance des éléments électrochimiques peut être caractérisée suivant son état de charge et sa température et/ ou son état de vieillissement. Le courant maximum accepté en charge, qui peut par exemple être dû à un dépôt de lithium au niveau d'une électrode négative de carbone (graphite ou autre), peut également dépendre de l'état de charge et de la température.

Ce mode de réalisation permet ainsi de gérer la fin de charge des éléments électrochimiques notamment par la connaissance de l'état de charge.

Selon un autre mode de réalisation, le procédé comprenant les étapes suivantes :

g1) fournir la valeur de la tension de fin de charge (Veoc) des éléments électrochimiques ;
g2) fournir un coefficient de fin de charge prédéterminé (Coef_eoc), le coefficient étant inférieur au nombre (p) d'éléments électrochimiques connectés en parallèle dans chaque branche ; et

et dans le cas d'un contrôle en intensité, avant l'étape e4 de transmission en temps réel à un régulateur de chargeur intégré dans la batterie de la valeur du courant maximal instantané de charge (IMR_parallel ou IMR_C_parallel) :

h1) après l'étape e3 de détermination en temps réel du courant maximal instantané de charge (IMR_parallel ou IMR_C_parallel) à appliquer aux éléments électrochimiques, on réalise une étape de détermination (S50) en temps réel d'un premier courant maximal instantané intermédiaire de charge égal au maximum entre le courant maximal seuil instantané de charge évalué et le produit du courant de charge maximal prédéterminé (IMR, IMR_C) autorisé par le coefficient de fin de charge (Coef_eoc) ;
h2) parallèlement aux étapes (S12) à S(50), on évalue (S52) en temps réel d'un second courant maximal instantané de charge intermédiaire en fonction de la valeur de la tension de fin de charge (Veoc), en régulant le second courant maximal seuil instantané de charge de sorte que la tension maximale (Vmax) des éléments électrochimiques soit égale à la tension de fin de charge (Veoc) ;

h3) détermination (S54) en temps réel d'un courant maximal instantané de charge (IMR_parallel ou IMR_C_parallel) à appliquer aux éléments électrochimiques, dans lequel le courant maximal instantané de charge est égal au minimum entre le premier et le second courant maximal instantané intermédiaire de charge évalués

et dans le cas d'un contrôle en tension, avant l'étape d d'évaluation en temps réel d'une tension de contrôle, on réalise les étapes suivantes :

i3) mise à jour (S72) d'une variable de fin de charge notée (Flag_eoc), initialement égale à zéro ; et
i4) tant que cette variable de fin de charge (Flag_eoc) vaut zéro, on réalise :

- l'étape d d'évaluation en temps réel d'une tension de contrôle ; et
- si la valeur du courant instantanée de la batterie est supérieure au produit du coefficient de fin de charge (Coef_eoc) par la valeur du courant de charge maximal autorisé prédéterminé (IMR, IMR_C), on transmet en temps réel à un régulateur de chargeur intégré dans la batterie la valeur de la tension de contrôle (Vcontrol, Vcontrol_C) évaluée à l'étape d de manière à alimenter les éléments électrochimiques de la batterie ;

i5) si cette variable de fin de charge (Flag_eoc) vaut un ou si la valeur du courant instantanée de la batterie est inférieure ou égale au produit du coefficient de fin de charge (Coef_eoc) par la valeur du courant de charge maximal autorisé prédéterminé (IMR, IMR_C), on réalise une étape (S74) d'évaluation d'une seconde tension de contrôle, en régulant le courant maximal prédéterminé de charge autorisé instantané de sorte que la valeur du courant instantanée de la batterie soit égale au produit du coefficient de fin de charge Coef_eoc par la valeur du courant de charge maximal autorisé prédéterminé (IMR, IMR_C) ; et

- si cette seconde tension de contrôle évaluée est inférieure à la tension de fin de charge (Veoc), on transmet en temps réel à un régulateur de chargeur intégré dans la batterie la seconde tension de contrôle (Vcontrol, Vcontrol_C) évaluée de manière à alimenter les éléments électrochimiques de la batterie ;
- sinon on transmet en temps réel à un régulateur de chargeur intégré dans la batterie la tension de fin de charge (Veoc) de manière à alimenter les éléments électrochimiques de la batterie.

Ce mode de réalisation permet sans la connaissance de l'état de charge (SOC) de réaliser la fin de la charge sur la zone pentue, ie de variations très rapide de la tension à vide avec l'état de charge (SOC), du couple à la différence du mode de réalisation précédent qui nécessite la connaissance de l'état de charge (SOC).
Selon un sous-mode de réalisation préféré, le coefficient de fin de charge (Coef_eoc) est égal à 1 afin d'empêcher tout risque de dépassement du courant de charge au niveau d'un élément électrochimique lors de la fin de charge de la batterie.
Selon une variante de ce sous-mode de réalisation préféré, le coefficient de fin de charge (Coef_eoc) est compris entre le tiers et la moitié du nombre d'éléments électrochimiques par branche. Une telle valeur permet de prévenir tout courant élevé au niveau d'un élément électrochimique tout en diminuant le temps de charge par rapport à une valeur égale à 1. Ces valeurs sont préférées dans le cas de système présentant une variation de la tension à vide (OCV) en fonction de l'état de charge de l'ordre de 500 mV/10 % de capacité au niveau de l'élément comme c'est le cas pour les éléments de type NCA/LFP qui seront définis par la suite.
L'invention a également pour objet un régulateur de charge de batterie comprenant une mémoire comprenant un programme qui met en oeuvre le procédé décrit ci-avant, dans lequel le régulateur limite ou fournit des informations permettant de limiter le courant de charge (I) à la valeur déterminée du courant maximal instantané autorisé en charge (IMR, IMR_C).
L'invention a également pour objet une batterie rechargeable comprenant au moins deux branches connectées en série, chaque branche comportant au moins deux éléments électrochimiques connectés en parallèle et un régulateur de charge tel que décrit précédemment, chaque élément électrochimique présentant un profil de charge (PC) comportant au moins une zone plateau directement suivie par une zone pentue dans lequel la variation de la tension en fonction de l'état de charge dans la zone plateau est en moyenne au moins 10 fois moins rapide que la variation de la tension dans la zone pentue.
Selon un mode de réalisation, chaque élément électrochimique est du type lithium-ion.
Selon un mode préféré, chaque élément électrochimique est de type lithium-ion comprenant au moins une matière active pour l'électrode positive choisie dans la liste consistant en :

- un composé, du type LMFP, de formule $Li_xMn_{1-y-z}M'_yM''_zPO_4$ où M' et M'' sont choisis dans le groupe consistant en B, Mg, Al, Si, Ca, Ti, V, Cr, Fe, Co, Ni, Cu, Zn, Y, Zr, Nb et Mo, et dans lequel M' et M'' sont différents l'un de l'autre, $0,8 \leq x \leq 1,2$, $0 \leq y \leq 0,6$ et $0 \leq z \leq 0,2$ ; et

- un composé, du type LFP, de formule $Li_xFe_{1-y}M_yPO_4$, où M est choisi dans le groupe consistant en B, Mg, Al, Si, Ca, Ti, V, Cr, Mn, Co, Ni, Cu, Zn, Y, Zr, Nb et Mo, et dans lequel $0,8 \leq x \leq 1,2$ et $0 \leq y \leq 0,6$.

Selon un autre mode préféré, chaque élément électrochimique est de type Lithium-ion dont l'électrode positive comprend :

a) un oxyde lithié comprenant de l'aluminium et des métaux de transition contenant au moins du nickel et du cobalt ; et
b) un phosphate lithié d'au moins un métal de transition ;

et dont la surface de l'électrode positive est recouverte au moins partiellement d'une couche de carbone ; et
et dans laquelle la proportion massique de l'oxyde lithié de métaux de transition contenant au moins du nickel, du cobalt et de l'aluminium est inférieure ou égale à 10 % du poids de la composition ;
et dans laquelle la proportion massique du phosphate lithié d'au moins un métal de transition étant supérieure ou égale à 90% du poids de la composition.

L'oxyde lithié de métaux de transition contenant au moins du nickel, cobalt et aluminium a pour formule $Li_w(Ni_x\text{-}Co_yAl_z)O_2$, où w va de 0,9 à 1,1 ; x > 0 ; y > 0 ; z > 0, et le phosphate lithié d'au moins un métal de transition a pour formule $Li_aM_bP_cO_{4-t}$ où M est choisi parmi Fe, Mn, Co et Ni, de préférence Fe; a, b et c vont de 0,9 à 1,1 ; t est inférieur ou égal à 0,4.

L'invention a également pour objet un produit de programme d'ordinateur comprenant au moins une séquence d'instructions stockées et accessibles à un processeur, où l'exécution du processeur conduit à la mise en oeuvre des étapes du procédé décrit ci-dessus.

L'invention a également pour objet un support d'information lisible par un ordinateur, permettant de mettre en oeuvre au moins une des séquences d'instructions du produit de programme d'ordinateur.

DESCRIPTION DES FIGURES

La figure 1 représente la variation à 30°C de la tension à vide en fonction de l'état de charge d'un élément dont l'électrode positive comprend une matière électrochimiquement active du type de celle décrite dans le document EP-A-2 269 954.

La figure 2 est un agrandissement schématique de la figure 1 dans la zone 23.

La figure 3 représente un schéma de principe du système de gestion de l'état de charge d'une batterie dans lequel une batterie comprend n branches, comportant chacune n éléments électrochimiques (Cell_p_n).

Les figures 4 à 12 représentent des organigrammes schématisant le principe de gestion de la charge d'une batterie selon différents modes de réalisation de l'invention et dans lesquels les notations utilisées sont relatives aux paramètres, tous définis comme positifs, suivants :

- p est le nombre d'éléments électrochimiques en parallèle par branche ;
- DTime est la période de mise à jour du programme qui exécuté par un processeur permet la mise en oeuvre du procédé de gestion de la charge selon l'invention ;
- IMR_C est le courant maximum de charge continu autorisé pour un élément électrochimique, exprimé en Ampère (A);
- IMR est le courant maximum de charge en mode pulsé autorisé pour un élément électrochimique, exprimé en Ampère (A);
- Veoc est la tension maximale de charge autorisé des éléments électrochimiques, exprimée en Volt (V) ;
- I est le courant instantané qui traversent la batterie ou cellule, exprimé en Ampère (A) avec I positif en charge;
- T est la température de la batterie ou le maximum des températures mesurées par des capteurs de température des éléments électrochimiques de la batterie à l'instant t. Elle est exprimée en degré Celsius (°C) ;
- Rcell est une table ou une loi prédéterminée permettant d'obtenir la valeur de la résistance interne d'un élément électrochimique en début de vie de la batterie selon la température de la batterie et éventuellement en fonction également de l'état de charge et/ou de l'état de vieillissement de la batterie. Elle est exprimée en Ohms ($\Omega$) ;
- Vmax(t) est le maximum des tensions aux bornes des éléments (ou cellules) électrochimiques de la batterie à l'instant t ;
- SOC est l'état de charge de la batterie ou des éléments (ou cellules) électrochimiques (%) ; et
- SOH est l'état de vieillissement de la batterie ou des éléments (ou cellules) électrochimiques (%).

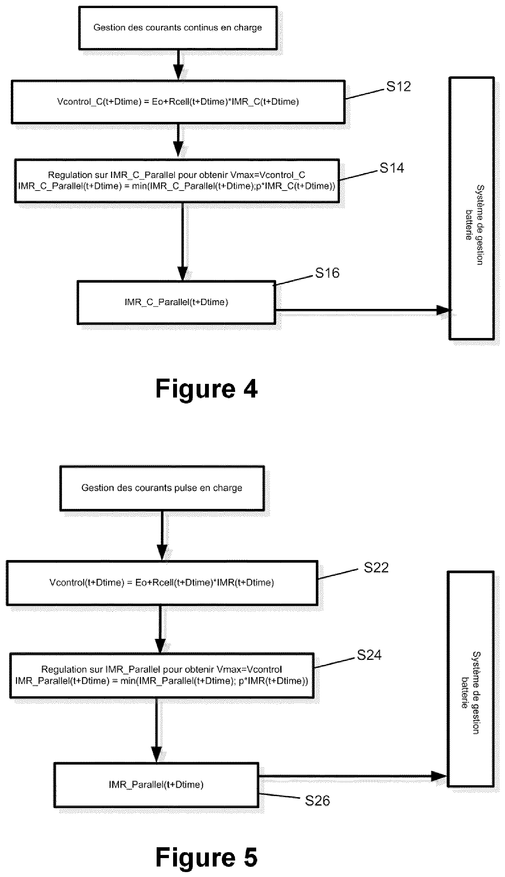

Les figures 4 et 5 représentent un organigramme schématisant le principe de gestion de la charge d'une batterie selon un premier mode de réalisation de l'invention par l'établissement d'une consigne en courant pour gérer les courants de charge continus ou en pulse des éléments, en prenant en compte uniquement la température (T) des éléments électrochimiques.

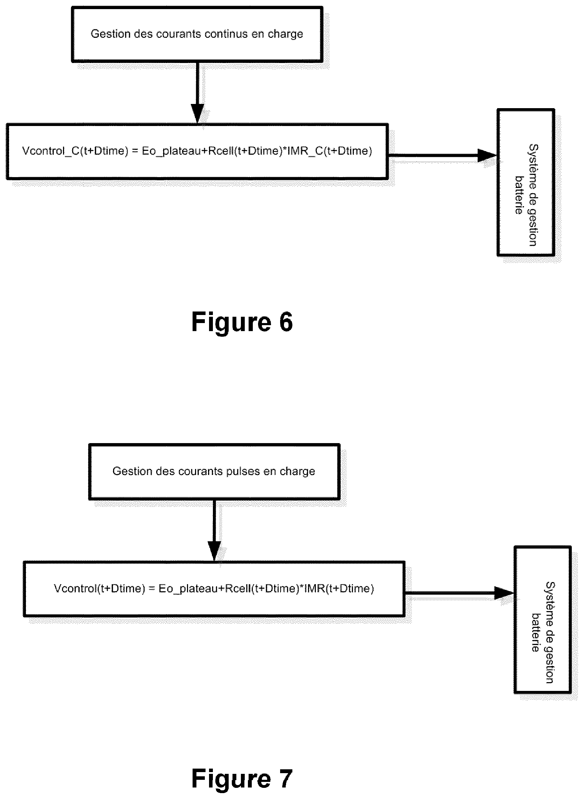

Les figures 6 et 7 représentent un organigramme schématisant le principe de gestion de la charge d'une batterie selon ce premier mode de réalisation de l'invention par l'établissement d'une consigne en tension.

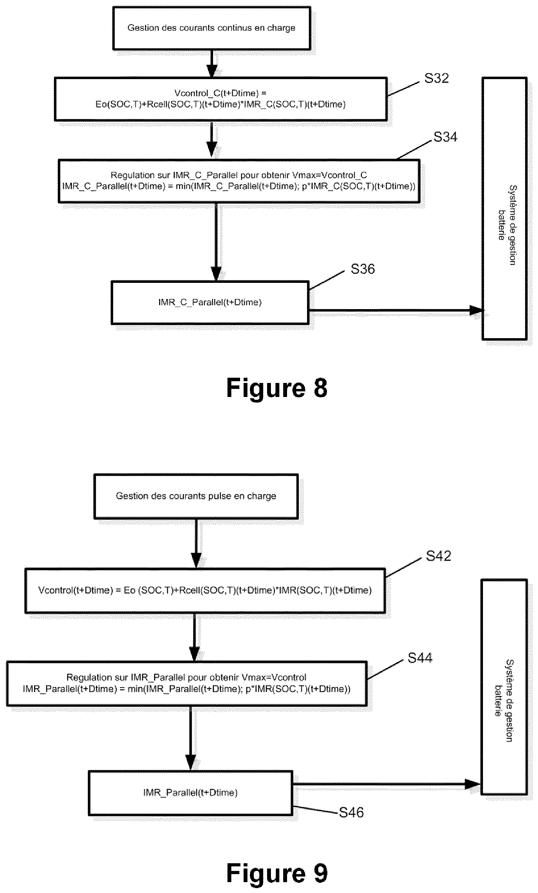

Les figures 8 et 9 représentent un organigramme schématisant le principe de gestion de la charge d'une batterie selon un second mode de réalisation de l'invention par l'établissement d'une consigne en courant pour gérer les courants de charge continus ou en pulse des éléments, en prenant en compte à la fois la température (T) et l'état de charge (SOC) des éléments électrochimiques.

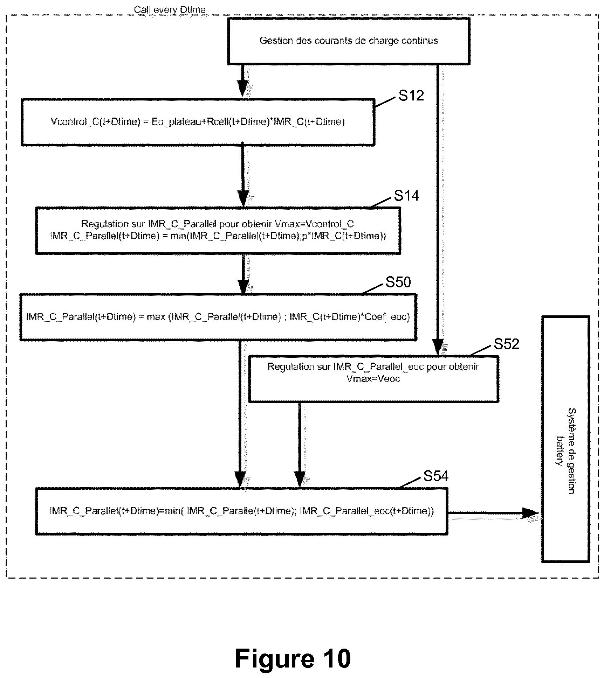

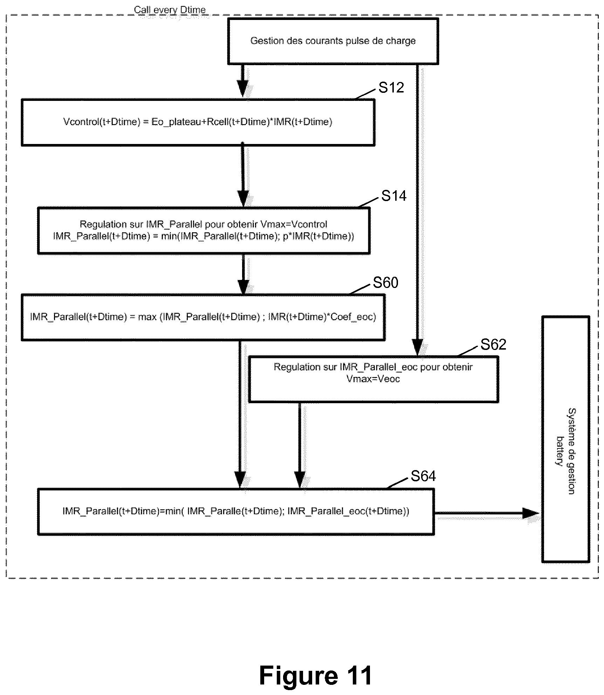

Les figures 10 et 11 représentent un organigramme schématisant le principe de gestion de la charge d'une batterie selon un troisième mode de réalisation de l'invention par l'établissement d'une consigne en courant.

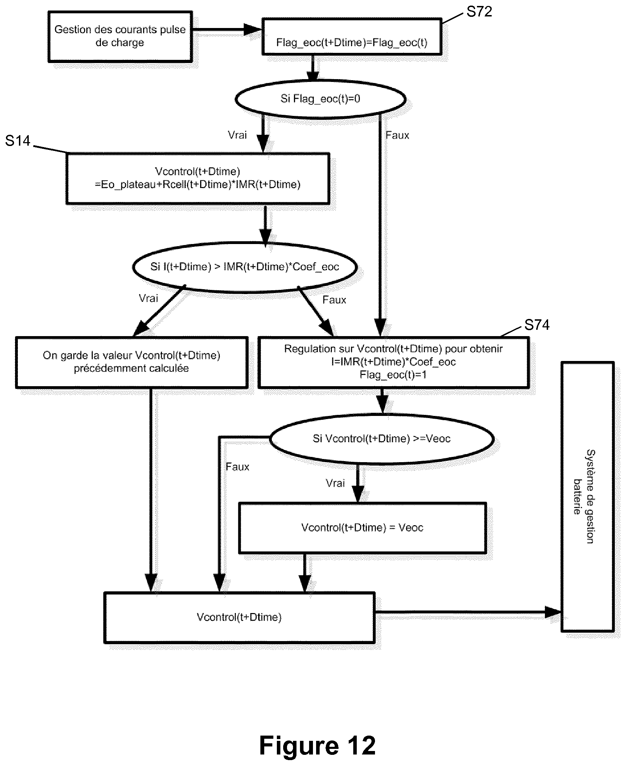

La figure 12 représente un organigramme schématisant le principe de gestion de la charge d'une batterie selon un troisième mode de réalisation de l'invention respectivement par l'établissement d'une consigne en tension permettant de gérer efficacement les courants de charge des éléments.

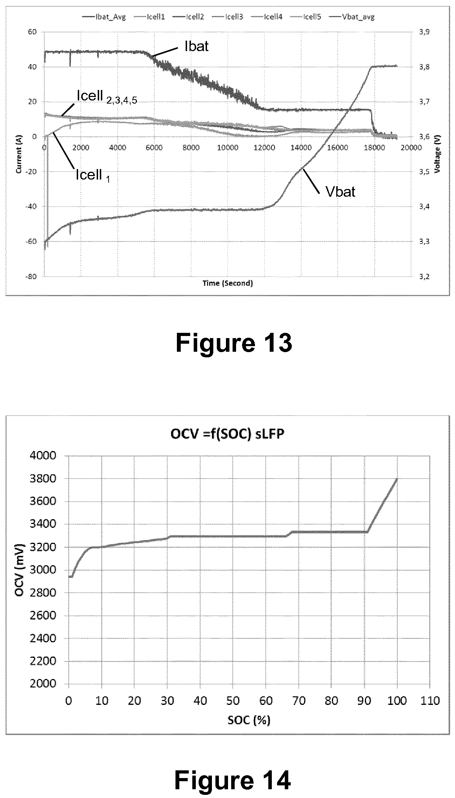

Les figures 13 à 18 illustrent des résultats obtenus par simulation permettant de comparer un procédé de gestion conventionnel à un procédé de gestion selon l'invention.

La figure 13 représente l'évolution du courant (Ibat) et de la tension (Vbat) de la batterie au cours de la charge, ainsi que l'évolution des courants dans chaque élément électrochimique (Icell_p pour p=1 à 5) de la batterie dans le cas où la charge de la batterie est gérée par un procédé selon le premier mode de réalisation de l'invention.

La figure 14 illustre le profil de charge des éléments électrochimiques utilisés dans les simulations.

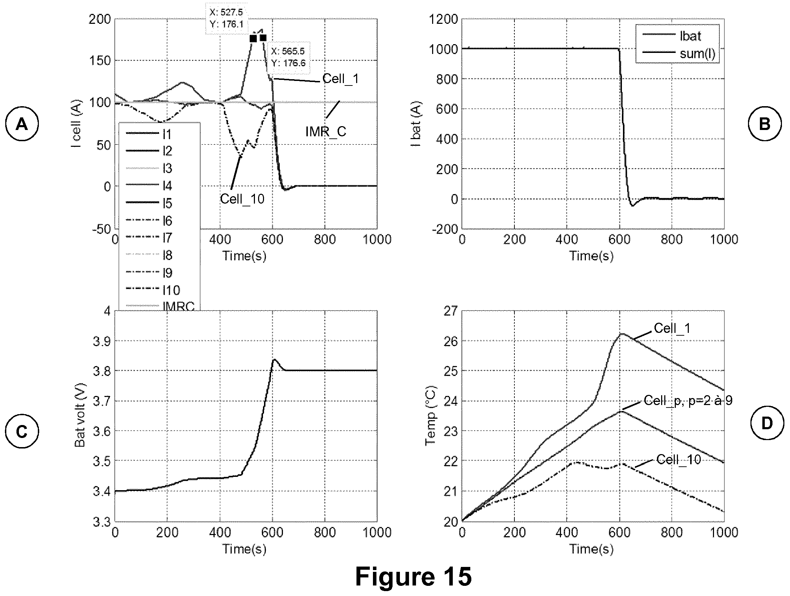

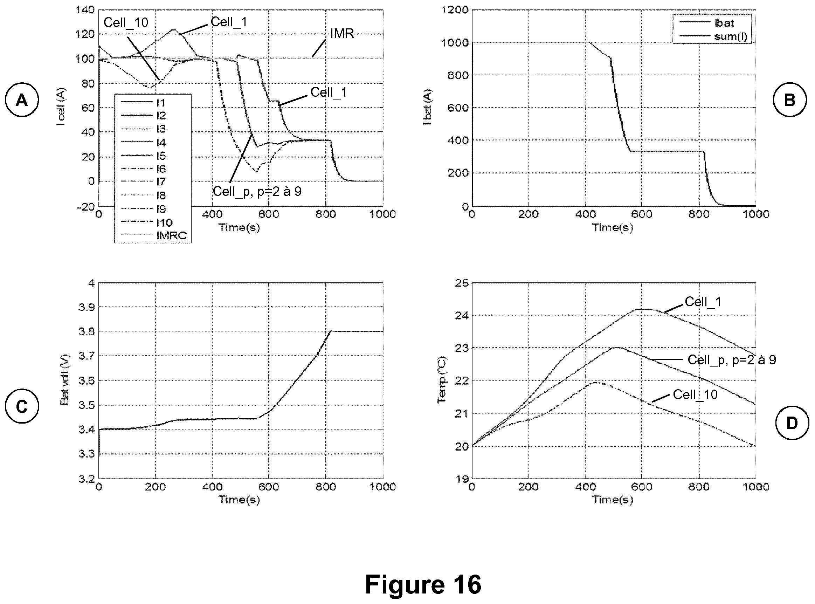

Les figures 15 et 16 sont relatives à la gestion de la charge en mode continu d'une batterie ayant des éléments d'une même branche initialement déséquilibrés respectivement selon un procédé de gestion conventionnel et selon l'invention.

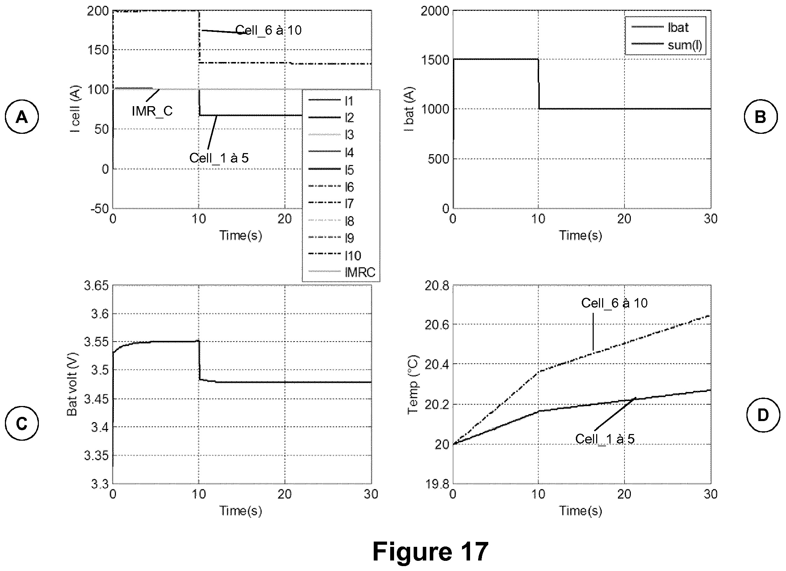

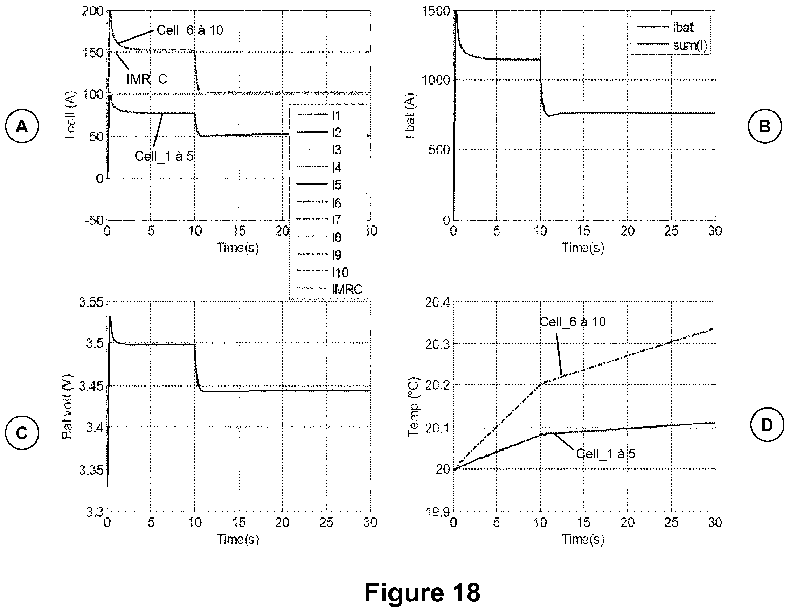

Les figures 17 et 18 sont relatives à la gestion de la charge en mode pulsé d'une batterie ayant des éléments d'une même branche initialement déséquilibrés, respectivement selon un procédé de gestion conventionnel et selon l'invention.

## DESCRIPTION DETAILLEE DE L'INVENTION

L'invention fournit une méthode pour gérer la charge d'une batterie rechargeable comportant au moins deux éléments directement connectés en parallèle sans risque de vieillissement prématuré des éléments.

### A - Description d'une batterie selon l'invention

La batterie selon l'invention comprend au moins deux branches connectées entre elles dans une configuration série, chaque branche comporte au moins deux éléments (ou cellules) électrochimiques Cell_p_n connectés entre eux dans une configuration parallèle et un régulateur de charge adapté à gérer la charge des éléments électrochimiques.

Chaque élément électrochimique Cell_p_n présente un profil de charge PC comportant au moins une zone plateau directement suivie par une zone pentue dans lequel la variation de la tension en fonction de l'état de charge dans la zone plateau est en moyenne au moins 10 fois moins rapide que la variation de la tension dans la zone pentue.

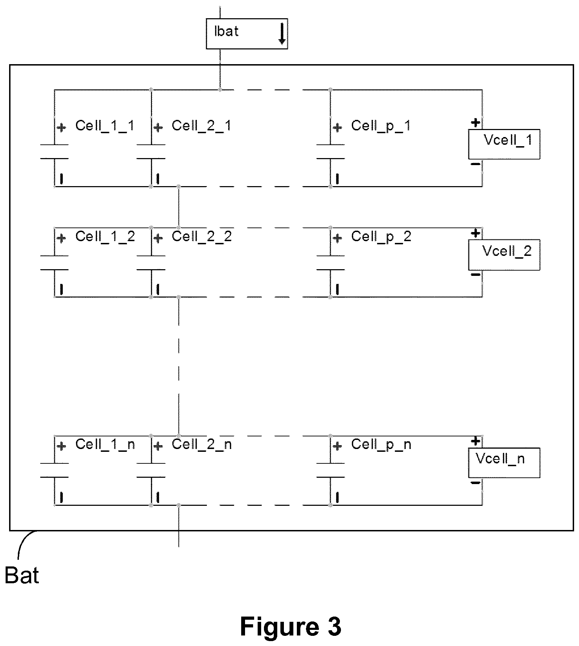

La figure 3 est un exemple de configuration dans laquelle p éléments électrochimiques E_1_1 à E_p_1 sont connectés en parallèle pour former une première branche ou module M1. De manière similaire, p éléments électrochimiques E_1_2 à E_p_2 sont connectés en parallèle pour former une seconde branche ou module M2 ; p éléments électrochimiques E_1_n à E_p_n sont connectés en parallèle pour former une n$^{\text{ème}}$ branche.

Les n branches sont connectées en série pour former une batterie Bat. Les branches de la batterie sont connectées à une source de courant qui peut être un chargeur ou une application fournissant un courant de charge non régulé comme c'est le cas dans un véhicule hybride lors du freinage au cours duquel de l'énergie mécanique est convertie en énergie électrique. La source de courant fournit un courant Ibat.

Chaque branche est munie d'un moyen de mesure de la tension à ses bornes Vcell_n. De préférence, un élément est aussi muni d'un moyen permettant de mesurer sa température de fonctionnement. Ce moyen de mesure est placé sur un point judicieusement choisi de l'élément afin d'avoir une représentation de sa température moyenne et/ou maximale et/ou minimale. Si la batterie comprend une pluralité d'éléments, chaque élément peut être muni d'un capteur de température mais cela rend plus complexe les circuits électroniques.

Dans le cas de branches regroupant différents éléments électrochimiques, les moyens de mesure de tension et de température peuvent être regroupés au sein d'un système électronique (Si), associé à une branche. Chaque système électronique peut également comprendre une mémoire permettant de stocker l'état du vieillissement des éléments. L'état de vieillissement d'un élément peut être caractérisé par le paramètre SOH (« State of Health ») qui indique le degré de vieillissement du module entre un état neuf et un état fin de vie. L'homme du métier a à sa disposition plusieurs techniques lui permettant de calculer l'état de vieillissement d'un élément ou d'un module. L'état de vieillissement d'un élément peut par exemple être calculé soit à partir du rapport de l'impédance de l'élément à un instant donné sur l'impédance de l'élément à l'état neuf à la même température, soit à partir de l'estimation de la perte de capacité par comparaison avec la capacité de l'élément à l'état neuf.

La batterie peut également comprendre un système adapté pour déterminer individuellement l'état de charge de chaque branche par exemple selon le procédé décrit dans la demande de brevet FR 1 251 925. Dans ce cas, le système comprend un système électronique de gestion G comprenant un calculateur qui :

- collecte la mesure du courant I traversant chaque branche;
- collecte les mesures de tension de chaque branche et éventuellement les mesures de température ;
- calcule l'état de charge SOC de chaque branche par coulométrie en prenant en compte l'erreur de mesure sur la valeur du courant;
- réalise l'estimation de l'état de charge de chaque branche selon la méthode de l'invention.

Seul l'état de charge « moyen » d'une branche, ie pour l'ensemble des éléments électrochimiques connectés en parallèle de la branche, est calculé puisque le courant traversant chaque élément électrochimique de la branche n'est pas mesuré afin d'optimiser la taille et le poids de l'ensemble du dispositif de charge et de la batterie.

De préférence, le système possède au moins un bus de communication (BUS) par exemple (CAN « Control Area Network », Ethernet) afin de fournir des informations sur l'état de l'élément ou de la batterie à un utilisateur.

De préférence encore, le calculateur collecte l'état de vieillissement des éléments.

Le système est adapté à l'estimation de l'état de charge d'éléments dont la matière active positive présente un profil de charge comportant au moins une zone plateau directement suivie par une zone pentue dans lequel la variation de la tension en fonction de l'état de charge dans la zone plateau est en moyenne au moins 10 fois moins rapide que la variation de la tension dans la zone pentue.

De préférence, chaque élément électrochimique est du type lithium-ion.

Selon un mode préféré, chaque élément électrochimique est de type Lithium-ion comprenant au moins une matière active pour l'électrode positive choisie dans la liste consistant en :

- un composé, du type LMFP, de formule $Li_xMn_{1-y-z}M'_yM''_zPO_4$ où M' et M'' sont choisis dans le groupe consistant en B, Mg, Al, Si, Ca, Ti, V, Cr, Fe, Co, Ni, Cu, Zn, Y, Zr, Nb et Mo, et dans lequel M' et M'' sont différents l'un de l'autre, $0,8 \leq x \leq 1,2$, $0 \leq y \leq 0,6$ et $0 \leq z \leq 0,2$ ; et
- un composé, du type LFP, de formule $Li_xFe_{1-y}M_yPO_4$, où M est choisi dans le groupe consistant en B, Mg, Al, Si, Ca, Ti, V, Cr, Mn, Co, Ni, Cu, Zn, Y, Zr, Nb et Mo, et dans lequel $0,8 \leq x \leq 1,2$ et $0 \leq y \leq 0,6$.

Selon un autre mode préféré, chaque élément électrochimique est de type Lithium-ion dont l'électrode positive comprend :

a) un oxyde lithié de métaux de transition contenant au moins du nickel, du cobalt et de l'aluminium ; et
b) un phosphate lithié d'au moins un métal de transition ;

et dont la surface de l'électrode positive est recouverte au moins partiellement d'une couche de carbone ; et
et dans laquelle la proportion massique de l'oxyde lithié de métaux de transition contenant au moins du nickel, du cobalt et de l'aluminium est inférieure ou égale à 10 % du poids de la composition ;
et dans laquelle la proportion massique du phosphate lithié d'au moins un métal de transition étant supérieure ou égale à 90% du poids de la composition.

L'oxyde lithié de métaux de transition contenant au moins du nickel, cobalt et aluminium a pour formule $Li_w(Ni_xCo_yAl_z)O_2$, où w va de 0,9 à 1,1 ; x > 0 ; y > 0 ; z > 0, et le phosphate lithié d'au moins un métal de transition a pour formule $Li_aM_bP_cO_{4-t}$ où M est choisi parmi Fe, Mn, Co et Ni, de préférence Fe; a, b et c vont de 0,9 à 1,1 ; t est inférieur ou égal à 0,4.

Une telle batterie est fournie avec des paramètres qui dépendent de la nature électrochimique des cellules ou éléments électrochimiques et de ses dimensions.

Les paramètres, tous définis comme positifs, comprennent ce qui suit :

- IMR_C est le courant maximum de charge continu autorisé pour un élément électrochimique, exprimé en Ampère (A);
- IMR est le courant maximum de charge en mode pulsé autorisé pour un élément électrochimique, exprimé en Ampère (A);
- Veoc est la tension maximale de charge autorisé des éléments électrochimiques, exprimée en Volt (V);

Le courant maximum de charge autorisé en continu IMR_C ou en en mode pulsé IMR peuvent être déterminés selon le procédé décrit dans le brevet US 7 940 027 B.

L'invention propose une méthode pour déterminer un courant de charge maximal autorisé (IMR_Parallel en pulse ou IMR_C_Parallel en continu) ou une tension de contrôle (Vcontrol en pulse ou Vcontrol_C en continu), en fonction du type de chargeur à chaque instant dans le temps. Pour fournir ces valeurs de courant de charge maximales autorisées instantanées ou de tension de contrôle, des variables sont mesurées ou déterminées :

- I est le courant instantané qui traversent la batterie ou cellule, exprimé en Ampère (A) avec I positif en charge;
- T est la température de la batterie ou le maximum des températures mesurées par des capteurs de température des éléments électrochimiques de la batterie à l'instant t. Elle est exprimée en degré Celsius (°C) ;
- Rcell est une table ou une loi prédéterminée permettant d'obtenir la valeur de la résistance interne d'un élément électrochimique en début de vie de la batterie selon la température de la batterie et éventuellement en fonction également de l'état de charge et/ou de l'état de vieillissement de la batterie. Elle est exprimée en Ohms ($\Omega$) ;
- Vmax(t) est le maximum des tensions aux bornes des éléments (ou cellules) électrochimiques de la batterie à l'instant t :

$$\text{Vmax(t)} = \text{max(Vcell\_1, Vcell\_2,..., Vcell\_n)}$$

- SOC est l'état de charge de la batterie ou des éléments (ou cellules) électrochimiques (%) ;
- SOH: l'état de vieillissement de la batterie ou des éléments (ou cellules) électrochimiques (%).

B) Description du procédé de gestion de la charge de la batterie

Le procédé de gestion de la charge d'une batterie rechargeable telle que décrite précédemment comporte une étape de fourniture des données caractéristiques des éléments électrochimiques. En particulier, les données caractéristiques fournies comprennent au moins des données relatives à la résistance interne d'un élément électrochimique de la batterie, une valeur de courant de charge maximal prédéterminé pour un élément autorisé et la valeur moyenne de la tension dans la zone plateau (E0_plateau).

La résistance interne (Rcell) d'un élément électrochimique peut dépendre de la température de la batterie. Dans ce cas, une fonction prédéterminée représentant la variation de la valeur de la résistance interne de la batterie en fonction de la température (T) est fournie.

De même, la valeur de courant de charge maximal prédéterminé pour un élément (IMR, IMR_C) autorisé dépend de la température (T).

B1) Description d'un premier mode de réalisation du procédé selon l'invention

Le procédé selon l'invention se propose de déterminer le courant de charge maximum continu autorisé instantané IMR_C_Parallel. L'organigramme de la figure 4 illustre le calcul de cette valeur dynamique du courant de charge autorisé.

Ce courant de charge maximal autorisé instantané IMR est calculé par un algorithme mis en oeuvre dans un contrôleur de charge associée à la batterie.

Le procédé comporte en outre une étape de mesure en temps réel de la tension Vcell_n aux bornes de chaque branche *n* d'éléments électrochimiques connectés en parallèle.

A partir de cette tension mesurée, on évalue en temps réel la tension maximale Vmax des éléments électrochimiques de la batterie définie comme étant le maximum des tensions mesurées Vcell_n aux bornes de chaque branche n.

Le procédé comprend également une mesure en temps réel de la température T de la batterie rechargeable.

Le procédé se poursuit par une étape S12 d'évaluation en temps réel d'une tension de contrôle Vcontrol_C égale à la somme de la valeur moyenne de la tension dans la zone plateau E0_plateau et du produit de la valeur de la résistance interne Rcell d'un élément électrochimique par la valeur du courant de charge maximal prédéterminé IMR_C autorisé en fonction de la température T mesurée :

$$\text{Vcontrol\_C}(t + \text{Dtime}) = \text{E0\_plateau} + \text{Rcell}(t + \text{Dtime}) \times \text{IMR\_C}(t + \text{Dtime})$$

pour une gestion des courants continus en charge. Dtime est la période de mise à jour du programme réalisant la gestion de la charge selon le procédé, ie la fréquence de rafraichissement des données mesurées ou calculées.

A partir de cette tension de contrôle Vcontrol_C évaluée, on évalue en temps réel, en S14, un courant maximal seuil instantané de charge traversant les éléments électrochimiques connectés en parallèle en fonction de la tension de contrôle évaluée Vcontrol_C en régulant le courant maximal seuil instantané de charge de sorte que la tension maximale Vmax des éléments électrochimiques soit égale à la tension de contrôle évaluée Vcontrol_C.

Par exemple, le courant maximal seuil instantané de charge est diminué de sorte que la tension maximale Vmax des éléments électrochimiques soit égale à la tension de contrôle évaluée Vcontrol_C tant que la tension maximale Vmax est supérieure à la tension de contrôle évaluée Vcontrol_C, et le courant maximal seuil instantané de charge est augmenté de sorte que la tension maximale Vmax des éléments électrochimiques soit égale à la tension de contrôle évaluée Vcontrol_C tant que la tension maximale Vmax est inférieure ou égale à la tension de contrôle évaluée Vcontrol_C.

Selon d'autres exemples, la régulation peut être de type proportionnel, intégral, dérivée et leurs combinaisons, de type tout ou rien, à hystérésis, de type par retour d'état ou utilisant un observateur d'état.

Cette étape de régulation est équivalente à une méthode bien connue de charge des batteries dite CCCV selon l'acronyme anglais « Constant Current, Constant Voltage » réalisé sur la consigne de courant maximal utilisable.

Un courant maximal instantané de charge IMR_C_parallel peut alors être déterminé en temps réel. Celui-ci est destiné à être appliqué aux éléments électrochimiques. Le courant maximal instantané de charge IMR_C_parallel est calculé de sorte à être égal au minimum entre le courant maximal seuil instantané de charge évalué et le produit entre le nombre *p* d'éléments électrochimiques par branche et le courant de charge maximal autorisé IMR_C prédéterminé :

$$IMR\_C\_Parallel = \min(IMR\_C\_Parallel\,;\,p \times IMR\_C)$$

pour une gestion des courants continus en charge.

Cette valeur du courant maximal instantané de charge IMR_C_parallel déterminée est transmise, en S16, en temps réel à un régulateur de chargeur intégré dans la batterie de manière à alimenter les éléments électrochimiques de la batterie avec une intensité inférieure ou égale au maximum de courant maximal instantané de charge déterminé.

La figure 5 illustre le procédé selon l'invention appliqué à la gestion de la charge des courants en mode pulsé. Les étapes décrites précédemment pour le mode continu s'appliquent toutes au mode pulsé en remplaçant les paramètres relatifs au mode continu par les paramètres relatifs au mode pulsé, ie respectivement en remplaçant :

- la tension de contrôle en continu Vcontrol_C par la tension de contrôle en mode pulsé Vcontrol ;
- le courant de charge maximal autorisé IMR_C en continu par IMR en mode pulsé ; et
- le courant maximal instantané de charge IMR_C_parallel en continu par IMR_parallel en mode pulsé.

Dans le mode de réalisation illustré en figure 4 pour le mode continu, le courant de charge maximum autorisé en mode continu IMR_C_Parallel ne peut excéder p fois la valeur maximale par élément IMR_C, soit *p* x IMR_C, où *p* fois est le nombre d'éléments électrochimiques par branche. Une saturation de la valeur du courant de charge maximum autorisé en mode continu IMR_C_Parallel à cette valeur maximale permet d'augmenter la robustesse de l'algorithme vis-à-vis d'éventuelles imprécisions de mesure par exemple de la tension, ou d'éventuelles imprécisions des caractéristiques, par exemple des résistances des éléments ou d'un éventuel dépassement de la consigne par le régulateur. Ceci s'applique également au courant de charge maximum autorisé en mode pulsé, illustré sur la figure 5, IMR_Parallel qui ne peut excéder *p* fois la valeur maximale par élément IMR, soit *p* x IMR.

Ainsi le procédé de gestion de charge selon ce mode de réalisation permet de fournir une consigne de courant maximum autorisé en mode continu IMR_C_Parallel(t+DTime) ou en mode pulsé IMR_Parallel(t+DTime) à un chargeur à l'instant t+Dtime qui ne peuvent être calculé directement puisque les résistances internes des éléments électrochimiques connectés directement en parallèle ne sont pas connues à chaque instant.

En outre, il permet également de fournir la tension maximale Vcontrol_C pour une charge continue ou Vcontrol pour bénéficier de la capacité de pulse des batteries.

Le premier mode de réalisation illustré sur les figures 4 (en mode continu) et 5 (en mode pulsé) est adapté à une gestion de la charge de la batterie par un contrôle en intensité, également appelé par une consigne en courant fournie au chargeur. Il permet de garantir le courant maximum traversant chaque élément, en fournissant au chargeur une consigne de courant.

Les figures 6 et 7 illustrent une alternative à ce premier mode de réalisation d'un procédé de gestion de la charge d'une batterie selon l'invention permettant de garantir le courant maximum traversant chaque élément, en fournissant au chargeur une consigne de tension Vcontrol_C ou Vcontrol respectivement en mode continu ou en mode pulsé.

Dans le cas des chargeurs adaptés pour recevoir une consigne en tension, le procédé de gestion de la charge de la batterie est effectué par un contrôle en tension et comporte la même étape de fourniture des données caractéristiques des éléments électrochimiques décrite précédemment. En particulier, les données caractéristiques fournies comprennent au moins des données relatives à la résistance interne Rcell d'un élément électrochimique de la batterie, une valeur de courant de charge maximal autorisé prédéterminé pour un élément IMR (en mode pulsé), IMR_C (en mode continu) et la valeur moyenne de la tension dans la zone plateau (E0_plateau).

Le procédé comprend en outre une mesure en temps réel de la température T de la batterie rechargeable.

En regard de la figure 6 pour le mode continu, le procédé se poursuit par la même étape S12 d'évaluation en temps réel d'une tension de contrôle Vcontrol_C égale à la somme de la valeur moyenne de la tension dans la zone plateau E0_plateau et du produit de la valeur de la résistance interne Rcell d'un élément électrochimique par la valeur du courant de charge maximal prédéterminé IMR_C autorisé en fonction de la température T mesurée :

$$Vcontrol\_C(t + Dtime) = E0\_plateau + Rcell(t + Dtime) \times IMR\_C(t + Dtime)$$

pour une gestion des courants continus en charge.

Cette valeur de la tension de contrôle Vcontrol_C déterminée définit une tension de consigne qui est transmise en temps réel à un régulateur de chargeur intégré dans la batterie de manière à charger les éléments électrochimiques de la batterie sous cette tension de contrôle.

Bien entendu, ce procédé de gestion de la charge d'une batterie par un contrôle en tension est adapté aussi bien en mode continu qu'en mode pulsé. Dans ce cas illustré en figure 7, le procédé se poursuit par la même étape S22 d'évaluation en temps réel d'une tension de contrôle Vcontrol égale à la somme de la valeur moyenne de la tension dans la zone plateau E0_plateau et du produit de la valeur de la résistance interne Rcell d'un élément électrochimique par la valeur du courant de charge maximal prédéterminé IMR autorisé en fonction de la température T mesurée :

$$Vcontrol(t + Dtime) = E0\_plateau + Rcell(t + Dtime) \times IMR(t + Dtime)$$

pour une gestion des courants continus en charge.

C'est cette tension Vcontrol qui définit une tension de consigne qui est transmise en temps réel à un régulateur de chargeur intégré dans la batterie de manière à charger les éléments électrochimiques de la batterie sous cette tension de contrôle.

B2) Description d'un deuxième mode de réalisation du procédé selon l'invention

Dans les modes de réalisation illustrés en figures 4 à 7, les valeurs de la résistance interne Rcell, du courant de charge maximal prédéterminé IMR et IMR_C et de la tension dans la zone plateau E0 ne dépendent que de la température T de la batterie.

Or ces valeurs peuvent dépendre également de l'état de charge de chaque élément électrochimique SOC et de l'état de vieillissement de chaque élément électrochimique SOH.

En effet, la valeur de la tension dans la zone plateau E0 peut dépendre de l'état de charge de la batterie SOC et de la température, voire de son état de vieillissement. De même, la valeur de la résistance interne Rcell des éléments électrochimiques peut être caractérisée suivant son état de charge et sa température, voire même en fonction de son état de vieillissement. Le courant maximum autorisé en charge IMR ou IMR_C, qui peut par exemple être dû à un dépôt de lithium au niveau d'une électrode négative de carbone (graphite ou autre), peut également dépendre de l'état de charge et de la température, voire de l'état de vieillissement.

L'invention propose donc un procédé de charge adapté pour prendre en compte ses dépendances et les variations de ces paramètres en fonction de la température T et/ou de l'état de charge de chaque élément électrochimique SOC et/ou de l'état de vieillissement de chaque élément électrochimique SOH.

Selon ce mode de réalisation, le procédé comporte en outre une étape de mesure de l'état de charge de chaque élément électrochimique SOC et/ou l'état de vieillissement de chaque élément électrochimique SOH en temps réel.

De plus, on substitue l'étape de fourniture des données caractéristiques des éléments électrochimiques par une autre étape de fourniture de données caractéristiques des éléments électrochimiques comprenant au moins :

- une fonction prédéterminée représentant la variation de la valeur de la résistance interne Rcell d'un élément électrochimique de la batterie en fonction de la température T et de l'état de charge de chaque élément électrochimique SOC et/ou de l'état de vieillissement de chaque élément électrochimique SOH,

- une valeur de courant de charge maximal autorisé prédéterminé IMR en mode pulsé ou IMR_C en mode continu en fonction de la température T et de l'état de charge de chaque élément électrochimique SOC et/ou de l'état de vieillissement de chaque élément électrochimique SOH, et
- la valeur de la tension dans la zone plateau E0 en fonction de la température T et de l'état de charge de chaque élément électrochimique SOC et/ou de l'état de vieillissement de chaque élément électrochimique SOH.

En outre, on substitue l'étape S12 ou S22 d'évaluation en temps réel de la tension de contrôle Vcontrol_C ou Vcontrol par une autre étape, S32 en mode continu ou S42 en mode pulsé, d'évaluation en temps réel de la tension de contrôle Vcontrol_C ou Vcontrol égale à la somme de la valeur moyenne de la tension dans la zone plateau E0 et du produit de la valeur de la résistance interne Rcell d'un élément électrochimique par la valeur du courant de charge maximal autorisé prédéterminé IMR_C ou IMR en fonction de la température T mesurée et le cas échéant, de l'état de charge de chaque élément électrochimique SOC mesuré et/ou de l'état de vieillissement de chaque élément électrochimique SOH mesuré.

Les figures 8 et 9 illustrent des exemples d'un tel procédé respectivement en mode continu et en mode pulsé dans lequel les valeurs de la résistance interne Rcell, du courant de charge maximal prédéterminé IMR et IMR_C et de la tension dans la zone plateau E0 dépendent à la fois de la température T de la batterie et de l'état de charge des cellules de la batterie.

Un tel état de charge de la batterie peut-être mesuré selon un procédé décrit dans la demande de brevet FR 1 251 925.

Dans ce second mode de réalisation illustré en figure 8 pour le mode continu comme dans le précédent, le courant de charge maximum autorisé en mode continu IMR_C_Parallel ne peut excéder *p* fois la valeur maximale par élément IMR_C, soit *p* x IMR_C, où *p* fois est le nombre d'éléments électrochimiques par branche. Une saturation de la valeur du courant de charge maximum autorisé en mode continu IMR_C_Parallel à cette valeur maximale permet d'augmenter la robustesse de l'algorithme vis-à-vis d'éventuelles imprécisions de mesure par exemple de la tension, ou d'éventuelles imprécisions des caractéristiques, par exemple des résistances des éléments ou d'un éventuel dépassement de la consigne par le régulateur. Ceci s'applique également au courant de charge maximum autorisé en mode pulsé IMR_Parallel qui ne peut excéder *p* fois la valeur maximale par élément IMR, soit *p* x IMR en regard de la figure 9.

Ce mode de réalisation permet de prendre en compte à la fois les fluctuations de la résistance interne, des courant maximum autorisé en charge et de la tension dans la zone plateau en fonction de la température de la batterie, de l'état de charge voire de l'état de vieillissement.

Grâce à la connaissance de l'état de charge, il est possible de charger de façon optimum les éléments électrochimiques de la batterie à la fois dans la zone plateau mais également en fin de charge.

Ceci permet notamment pour les couples présentant une faible pente sur le plateau de prendre la valeur précise de E0_plateau et non sa moyenne. Cela évite de surcharger l'élément si la tension moyenne est trop haute ou d'avoir des temps de charge augmentés si la tension moyenne est trop basse. Il en est de même pour la résistance où une valeur moyenne entraine localement des courants de charge légèrement trop importants ou des temps de charge augmentés.

B3) Description d'un troisième mode de réalisation du procédé selon l'invention

L'organigramme de la figure 10 illustre un algorithme mis en oeuvre dans un contrôleur de charge associée à la batterie pour calculer la valeur du courant de charge maximal autorisé instantané, selon un troisième mode de réalisation.

Dans l'exemple illustré en figure 10, les valeurs de la résistance interne, du courant maximum autorisé en charge et de la tension dans la zone plateau ne dépendent que de la température.

L'algorithme selon ce troisième mode de réalisation est identique à celui du premier mode de réalisation illustré sur la figure 4 pour les étapes S12 et S14 qui permettent de gérer la charge de la batterie dans la zone plateau du profil de charge (PC) des éléments électrochimiques de la batterie.

Afin de gérer la fin de charge de la batterie dans ce mode de réalisation, le procédé comporte une étape de fourniture de la tension de fin de charge Veoc des éléments électrochimiques.

En outre, le procédé comporte également une étape de fourniture d'un coefficient de fin de charge prédéterminé, noté Coef_eoc. Ce coefficient est inférieur au nombre p d'éléments électrochimiques connectés en parallèle dans chaque branche. Ce coefficient est caractéristique du passage de la charge sur la zone plateau du profil de charge PC à la phase plus pentue.

La valeur la plus robuste pour ce coefficient Coef_eoc est 1 car elle interdit tout courant supérieur au courant autorisé en fin de charge. Néanmoins, pour diminuer le temps de charge en fin de charge, on peut définir par des tests, par exemple des simulations par ordinateur ou par étalonnage, des valeurs de Coef_eoc supérieurs évitant de dépasser les courants de charge autorisés, typiquement entre p/2 et p/3, où p est le nombre d'éléments électrochimiques par branche connectés en parallèle.

Après l'étape S14 de détermination en temps réel du courant maximal instantané de charge en continue IMR_C_parallel à appliquer aux éléments électrochimiques et avant l'étape de transmission en temps réel à un régulateur de charge intégré dans la batterie de la valeur du courant maximal instantané de charge IMR_C_parallel, on réalise une étape S50 de détermination d'un premier courant maximal instantané intermédiaire de charge.

Le premier courant maximal instantané intermédiaire de charge est calculé en temps réel de sorte à être égal au maximum entre le courant maximal seuil instantané de charge évalué et le produit du courant de charge maximal prédéterminé autorisé IMR_C en continu par le coefficient de fin de charge Coef_eoc, en S50 :

$$\text{IMR\_C\_Parallel}(t + \text{Dtime}) = \max(\text{IMR\_C\_Parallel}(t + \text{Dtime}) ;$$
$$\text{IMR\_C}(t + \text{Dtime}) \times \text{Coef\_eoc})$$

Parallèlement aux étapes S12 à S50, un second courant maximal instantané de charge intermédiaire, noté IMR_C_Parallel_eoc, est évalué en S52. Par « parallèlement », on entend un second calcul ou évaluation indépendant de celui effectué aux étapes S12 à S50. Ces deux calculs peuvent être simultanés ou consécutifs. Ce second courant maximal instantané intermédiaire de charge est destiné à traverser les éléments électrochimiques connectés en parallèle. Pendant cette étape d'évaluation S52 du second courant maximal instantané intermédiaire de charge est évalué en temps réel en fonction de la valeur de la tension de fin de charge Veoc, en régulant le second courant maximal seuil instantané de charge de sorte que la tension maximale Vmax des éléments électrochimiques soit égale à la tension de fin de charge Veoc.

Par exemple, le second courant maximal instantané intermédiaire de charge IMR_C_Parallel_eoc est diminué de sorte que la tension maximale Vmax des éléments électrochimiques soit égale à la tension de fin de charge Veoc tant que la tension maximale Vmax est supérieure à la tension de fin de charge Veoc, et le second courant maximal instantané intermédiaire de charge est augmenté si la tension maximale Vmax est inférieure à la tension de fin de charge Veoc.

Selon d'autres exemples, la régulation peut être de type proportionnel, intégral, dérivée et leurs combinaisons, de type tout ou rien, à hystérésis, de type par retour d'état ou utilisant un observateur d'état.

Cette étape de régulation est également équivalente à une méthode bien connue de charge des batteries dite CCCV selon l'acronyme anglais « Constant Current, Constant Voltage » réalisé sur la consigne de courant maximal utilisable. Puis en S54, un courant maximal instantané de charge IMR_C_parallel est déterminé en temps réel. Ce courant maximal instantané de charge est destiné à être appliqué aux éléments électrochimiques. Il est déterminé de sorte à être égal au minimum entre le premier et le second courant maximal instantané intermédiaire de charge évalués, IMR_C_Parallel et IMR_C_Parallel_eoc :

$$\text{IMR\_C\_Parallel}(t + \text{Dtime}) = \min(\text{IMR\_C\_Parallel}(t + \text{Dtime}) ;$$
$$\text{IMR\_C\_Parallel\_eoc}(t + \text{Dtime}))$$

C'est cette valeur qui est ensuite transmise en temps réel à un régulateur de chargeur intégré dans la batterie de manière à alimenter les éléments électrochimiques de la batterie avec une intensité inférieure ou égale au maximum de courant maximal instantané de charge déterminé.

La valeur du premier courant maximal instantané intermédiaire de charge est adaptée pour gérer la charge dans la zone plateau et la valeur du second courant maximal instantané intermédiaire de charge est adapté pour gérer la fin de la charge sur la zone pentue du couple électrochimique même sans connaissance de l'état de charge SOC des éléments électrochimiques qui peut être difficile à obtenir.

La figure 11 illustre le procédé selon le troisième mode de réalisation de l'invention appliqué à la gestion de la charge des courants en mode pulse. Les étapes décrites précédemment pour le mode continu s'appliquent toutes au mode pulsé en remplaçant les paramètres relatifs au mode continu par les paramètres relatifs au mode pulsé, ie respectivement en remplaçant :

- la tension de contrôle en continu Vcontrol_C par la tension de contrôle en mode pulsé Vcontrol ;
- le courant de charge maximal autorisé IMR_C en continu par IMR en mode pulsé ; et
- le courant maximal instantané de charge IMR_C_parallel en continu par IMR_parallel en mode pulsé.

Ce troisième mode de réalisation est particulièrement bien adapté aux éléments électrochimiques dont le profil de charge présente une zone plateau suivi d'une variation très rapide de la tension à vide avec l'état de charge. Il permet, sans connaissance de l'état de charge SOC des éléments électrochimiques qui peut être difficile à obtenir, de réaliser la fin de la charge sur la zone pentue du couple.

Dans les exemples illustrés en figures 10 et 11, les valeurs de la résistance interne, du courant maximum autorisé en charge et de la tension dans la zone plateau ne dépendent que de la température. Bien entendue, leurs variations en fonction de l'état de charge voire de l'état de vieillissement pourront également être prises en compte comme dans le second mode de réalisation de sorte que la gestion de la charge est plus robuste.

Les modes de réalisation illustrés en figures 10 et 11 permettent de garantir le courant maximum traversant chaque élément, en fournissant au chargeur une consigne de courant.

La figure 12 illustre une alternative à ce troisième mode de réalisation d'un procédé de gestion de la charge d'une batterie selon l'invention permettant de garantir le courant maximum traversant chaque élément, en fournissant au chargeur une consigne de tension Vcontrol en mode pulsé. Bien entendu, les étapes décrites par la suite pour le mode pulsé peuvent être transposées au cas continu.

Selon cette alternative illustrée en figure 12 pour le mode pulsé, le procédé comporte la même étape de fourniture des données caractéristiques des éléments électrochimiques décrite précédemment. En particulier, les données caractéristiques fournies comprennent au moins des données relatives à la résistance interne Rcell d'un élément électrochimique de la batterie, une valeur de courant de charge maximal autorisé prédéterminé pour un élément IMR et la valeur moyenne de la tension dans la zone plateau (E0_plateau).

Le procédé comprend en outre une mesure en temps réel de la température T de la batterie rechargeable.

Afin de gérer la fin de charge de la batterie dans ce mode de réalisation, le procédé comporte également une étape de fourniture de la tension de fin de charge Veoc des éléments électrochimiques et d'un coefficient de fin de charge prédéterminé Coef_eoc comme précédemment décrit.

Le procédé comporte tout d'abord une étape S72 de mise à jour d'une variable de fin de charge notée Flag_eoc. La mise à jour est effectuée à la période Dtime de mise à jour de l'algorithme adapté pour gérer la charge de la batterie lorsqu'il est mis en oeuvre par un processeur. Cette variable vaut 1 lorsqu'on est en fin de charge de la batterie, ie dans la zone pentue du profil de charge et en dehors de cette zone cette variable est égale à zéro. Ainsi en fonction de sa valeur, lorsqu'on est dans la zone plateau du profil de charge, ie Flag_eoc(t)=0, le procédé comporte la même étape S22, que décrite précédemment, d'évaluation en temps réel d'une tension de contrôle Vcontrol égale à la somme de la valeur moyenne de la tension dans la zone plateau E0_plateau et du produit de la valeur de la résistance interne Rcell d'un élément électrochimique par la valeur du courant de charge maximal prédéterminé IMR autorisé en fonction de la température T mesurée :

$$Vcontrol(t+Dtime) = E0\_plateau + Rcell(t+Dtime) \times IMR(t+Dtime)$$

pour une gestion des courants en charge en mode pulsé.

C'est cette tension Vcontrol qui définit une tension de consigne qui est transmise en temps réel à un régulateur de chargeur intégré dans la batterie de manière à charger les éléments électrochimiques de la batterie sous cette tension de contrôle tant qu'on est encore dans la zone plateau du profil de charge, ie tant que la valeur du courant instantanée de la batterie est supérieure au produit du coefficient de fin de charge Coef_eoc par la valeur du courant de charge maximal autorisé prédéterminé en mode pulsé IMR :

$$I(t+Dtime) > IMR(t+Dtime) \times Coef\_eoc$$

Cette étape permet ainsi de gérer la charge de la batterie dans la zone plateau du profil de charge (PC) des éléments électrochimiques de la batterie.

Le passage du courant instantanée de la batterie a une valeur inférieure ou égale au produit du coefficient de fin de charge Coef_eoc par la valeur du courant de charge maximal autorisé prédéterminé en mode pulsé IMR : I(t+Dtime)≤IMR(t+Dtime)×Coef_eoc est caractéristique du passage de la zone plateau à la zone pentue du profil de charge. Cela signifie que les éléments électrochimiques de la batterie sont en fin de charge.

Ainsi dès que la valeur du courant instantanée de la batterie est inférieure ou égale au produit du coefficient de fin de charge Coef_eoc par la valeur du courant de charge maximal autorisé prédéterminé en mode pulsé IMR :

$$I(t+Dtime) \leq IMR(t+Dtime) \times Coef\_eoc$$, la variable de fin de charge notée Flag_eoc vaut 1.

Afin de gérer la fin de charge des éléments électrochimiques de la batterie, le procédé comporte une étape S74 d'évaluation d'une seconde tension de contrôle.

Cette étape est mise en oeuvre tant que la variable notée Flag_eoc vaut 1.

Pendant cette étape d'évaluation S74 de la seconde tension de contrôle est évaluée en temps réel en fonction de la valeur de la tension de fin de charge Veoc, en régulant le courant maximal prédéterminé de charge autorisé instantané de sorte que la valeur du courant instantanée de la batterie soit égale au produit du coefficient de fin de charge Coef_eoc par la valeur du courant de charge maximal autorisé prédéterminé en mode pulsé IMR : I(t + Dtime) = IMR(t + Dtime)×Coef_eoc.

Par exemple, la régulation est du type proportionnel, intégral, dérivée et leurs combinaisons, de type tout ou rien, à hystérésis, de type par retour d'état ou utilisant un observateur d'état.

Par la suite, si cette seconde tension de contrôle évaluée à l'étape S74 est inférieure à la tension de fin de charge Veoc, elle définit la tension de consigne qui est ensuite transmise en temps réel à un régulateur de chargeur intégré dans la batterie de manière à charger les éléments électrochimiques de la batterie sous cette tension de contrôle jusqu'à atteindre la fin de charge.

Sinon, ie si cette seconde tension de contrôle évaluée à l'étape S74 est supérieure ou égale à tension de fin de charge Veoc, la valeur de la seconde tension de contrôle est remplacée par la valeur de la tension de fin de charge et c'est cette valeur qui définit la tension de consigne qui est ensuite transmise en temps réel à un régulateur de chargeur intégré dans la batterie de manière à charger les éléments électrochimiques de la batterie sous cette tension de contrôle jusqu'à atteindre la fin de charge.

Bien entendu, ce procédé de gestion de la charge d'une batterie par un contrôle en tension est adapté aussi bien en mode continu qu'en mode pulsé.

Dans le troisième mode de réalisation de l'invention que la gestion de la charge soit contrôlée par une consigne en tension ou en intensité, un coefficient de fin de charge Coef_eoc égal à 1 empêche tout risque de dépassement du courant de charge au niveau d'un élément lors de la fin de charge de la batterie.

Selon un mode préféré, le coefficient de fin de charge est compris entre le tiers du nombre $p$ d'éléments électrochimiques par branche et la moitié de celui-ci. Une telle valeur permet de prévenir tout courant élevé au niveau d'un élément tout en diminuant le temps de charge par rapport à un coefficient de fin de charge égale à 1. Ces valeurs sont préférées dans le cas des systèmes de type NCA/LFP qui ont un profil de charge dont la variation de l'OCV en fonction de l'état de charge est de l'ordre de 500mV/10% de capacité au niveau élément dans la zone pentue.

C) Exemples

Les figures 13 à 16 illustrent des résultats obtenus par simulation permettant de comparer un procédé de gestion conventionnel à courant constant à un procédé de gestion selon l'invention.

Le premier système simulé est une batterie comportant 5 éléments du type NCA/LFP connectés directement en parallèle.

Le courant de charge est de 5x10 A car on souhaite dans l'idéal charger à IMR_C=10 A par élément connecté en parallèle.

Pour montrer l'effet technique réalisé par un procédé de gestion selon l'invention, l'élément 1, noté cell1 est chargé à 30% tandis que les autres éléments cell2 à cell5 sont chargés à 10% seulement. Par conséquent, les éléments électrochimiques sont initialement à des états de charge différents.

La figure 14 illustre le profil de charge des éléments électrochimiques utilisés dans les simulations.

La valeur moyenne du plateau E0_plateau est 3,333 V et la tension de fin de charge Veoc est de 3,8 V.

Le coefficient de fin de charge Coef_eoc pour le procédé de charge selon l'invention est égal à p/3 soit 5/3 et la régulation utilisée est du type proportionnel intégral (PI).

La figure 13 représente l'évolution du courant Ibat et de la tension Vbat de la batterie au cours de la charge, ainsi que l'évolution des courants dans chaque élément électrochimique Icell_p pour p=1 à 5 dans le cas où la charge de la batterie est gérée par un procédé selon le premier mode de réalisation de l'invention.

On constate que les dépassements de courant sont faibles et uniquement à bas état de charge, ce qui est une zone où l'électrode négative supporte de plus forts courants de charge. Il n'y a aucun dépassement à fort état de charge de la consigne IMR_C sur la phase à courant constant.

Le temps de charge est proche du temps de charge optimum en considérant le courant maximum de charge de 10A.

D'autres régulations sont bien entendues possibles comme par exemple une régulation à tension constante au seuil Vcontrol_C en utilisant par exemple un asservissement du courant de type proportionnel intégral ou toute autre régulation connue de l'homme de l'art.

Un second système simulé est une batterie comportant 10 éléments du type NCA/LFP connectés directement en parallèle. Cette fois une régulation plus fine est utilisée sur le courant afin d'optimiser la durée dite « d'équilibrage ».

A cet effet, la batterie est chargée selon un courant de consigne égal à IMR_C*p (avec p=10 ici). La régulation est effectuée selon un algorithme dit « Intensité Maximale de Regen Intensité Maximale de Décharge » ou IMDIMR selon le procédé décrit dans le brevet US 7 940 027. Au cours de cette étape de régulation, IMR_C est égal à la valeur continue autorisée en charge, et les courants de pulse IMR sont autorisés tant que la variable interne relative à la capacité de surcharge Cap dans cet algorithme IMRIMD est positive. La capacité de surcharge Cap est définie comme l'intégrale de la différence entre le courant de charge instantanée et la charge maximale en courant continu. Elle décroit lorsque la différence entre les valeurs des courants maximum autorisés en charge en pulse et en continu est positive (IMR-IMR_C>0) et inversement. Le but de l'invention est de ne pas dépasser IMR_C pour chaque élément sous peine d'un risque de sur-vieillissement de l'élément en question.

Premier cas : Charge continue

• Caractéristique de la batterie

  ◦ Batterie de 10 éléments connectés directement en parallèle de type NCA/LFP
  ◦ Un des éléments électrochimiques est initialement chargé à 30% (SOC_cell1=30%), un autre à 50% (SOCcell10=50%) et les 8 autres à 40% (SOCcellp=40% pour p=2 à 9).

• Caractéristique des éléments électrochimiques

La figure 14 illustre le profil de charge des éléments électrochimiques utilisés dans les simulations. La valeur moyenne du plateau E0_plateau est 3,333 V et la tension de fin de charge Veoc est de 3,8 V.
La valeur des résistances internes est 1,1 mOhm et le courant maximal de charge par élément est IMR_C=100 A.
La figure 15 illustre les résultats obtenus par simulation selon un procédé de gestion conventionnel du type CCCV limitée par 10x100A en courant et 3,8V en tension par une régulation du type proportionnel intégral.
La figure 15A représente l'évolution des courants dans chaque élément électrochimique Icell_p pour p=1 à 10 au cours de la charge.
Les figures 15B et C illustrent respectivement l'évolution du courant Ibat et de la tension Vbat de la batterie au cours de la charge.
La figure 15D représente l'évolution de la température des éléments électrochimique Icell_p pour p=1 à 10 au cours de la charge.
On constate que cette charge classique conduit à un courant de plus de 175 A en fin de charge (pour t > 400s) pendant 38 s dans l'élément le moins chargé initialement cell_1 alors que le courant max de charge autorise est de 100A, entrainant ainsi un vieillissement prématuré de la batterie.
La figure 16 illustre les résultats obtenus par simulation selon un procédé de gestion selon l'invention dans lequel le coefficient de fin de charge est égal à p/3 soit 10/3 et par une régulation du type proportionnel intégral.
La figure 16A représente l'évolution des courants dans chaque élément électrochimique Icell_p pour p=1 à 10 au cours de la charge.
Les figures 16B et C illustrent respectivement l'évolution du courant Ibat et de la tension Vbat de la batterie au cours de la charge.
La figure 16D représente l'évolution de la température des éléments électrochimique Icell_p pour p=1 à 10 au cours de la charge.
On constate que le courant maximal en fin de charge (pour t > 400s) respecte la consigne de courant de 100A donnée pour cet élément, et donc supprime tout risque de vieillissement prématuré de l'élément.
De plus, le temps de charge est optimal, car l'élément cell1 qui reçoit le plus de courant suit exactement la consigne maximale de courant que peut supporter l'élément, excepté en fin de charge. Il n'y a pas de réduction de performance de la batterie.

Deuxième cas : Charge en mode pulsé

• Caractéristique de la batterie

  ◦ Batterie de 10 éléments connectés directement en parallèle de type NCA/LFP
  ◦ Tous les éléments électrochimiques sont initialement chargés à 65% (SOC_cellp=65%).

- Caractéristique des éléments électrochimiques

La figure 14 illustre le profil de charge des éléments électrochimiques utilisés dans les simulations. La valeur moyenne du plateau E0_plateau est 3,333 V et la tension de fin de charge Veoc est de 3,8 V.

La valeur des résistances internes est 1,1 mOhm pour les éléments 1 à 5 et 2.2mOhm pour les éléments 6 à 10.

Le courant continu maximal de charge par élément est IMR_C=100 A et le courant pulse maximal de charge par élément : IMR =150A pendant 10s.

La figure 17 illustre les résultats obtenus par simulation selon un procédé de gestion conventionnel du type CCCV limitée en courant par 10*150A pendant 10s puis à 10*100A et 3,8V en tension par une régulation du type proportionnel intégral.

La figure 17A représente l'évolution des courants dans chaque élément électrochimique Icell_p pour p=1 à 10 au cours de la charge.

Les figures 17B et C illustrent respectivement l'évolution du courant Ibat et de la tension Vbat de la batterie au cours de la charge.

La figure 17D représente l'évolution de la température des éléments électrochimique Icell_p pour p=1 à 10 au cours de la charge.

Cette charge classique conduit à un courant pulse de 200A sur les éléments 1 à 5 pendant les 10s du pulse autorisé à 150A, puis à un dépassement également lors de la phase ultérieure au pulse entraînant ainsi un vieillissement prématuré de la batterie.

La figure 18 illustre les résultats obtenus par simulation selon un procédé de gestion selon l'invention dans lequel le coefficient de fin de charge est égal à p/3 soit 10/3 et par une régulation du type proportionnel intégral.

La figure 18A représente l'évolution des courants dans chaque élément électrochimique Icell_p pour p=1 à 10 au cours de la charge.

Les figures 18B et C illustrent respectivement l'évolution du courant Ibat et de la tension Vbat de la batterie au cours de la charge.

La figure 18D représente l'évolution de la température des éléments électrochimique Icell_p pour p=1 à 10 au cours de la charge.

Le courant maximal de charge respecte la consigne de 150A donnée par pulse après le temps caractéristique de réponse du régulateur, puis 100A pour tous les éléments, et supprime donc tout risque de vieillissement prématuré des éléments.

De plus, le temps de charge est optimal, car le courant des éléments qui reçoivent le plus de courant suit exactement la consigne maximale de courant que ceux-ci peuvent supporter. Il n'y a donc pas de réduction de performance de la batterie.

La solution alternative pour être sûr de ne pas faire sur-vieillir la batterie serait de la charger à un courant maximum autorisé IMR au niveau batterie de 150A puis 100A. Néanmoins, le temps de charge serait multiplié par 10, ce qui serait une très forte réduction de performance de la batterie.

**Revendications**

1. Procédé de gestion de la charge d'une batterie rechargeable par un contrôle en tension ou par un contrôle en intensité comprenant une pluralité (n) de branches connectées en série, chaque branche comportant une pluralité (p) d'éléments électrochimiques connectés en parallèle, chaque élément électrochimique présentant un profil de charge (PC) comportant au moins une zone plateau directement suivie par une zone pentue dans lequel la variation de la tension en fonction de l'état de charge dans la zone plateau est en moyenne au moins 10 fois moins rapide que la variation de la tension dans la zone pentue, le dit procédé comprenant les étapes suivantes :

   a) fournir des données caractéristiques des éléments électrochimiques, les données caractéristiques comprenant au moins :

      • une fonction prédéterminée représentant la variation de la valeur de la résistance interne (Rcell) d'un élément électrochimique de la batterie en fonction de la température (T),
      • une valeur de courant de charge maximal prédéterminé pour un élément (IMR, IMR_C) autorisé en fonction de la température (T), et
      • la valeur moyenne de la tension dans la zone plateau (E0_plateau),

   e) mesure en temps réel de la tension (Vcell_n) aux bornes de chaque branche d'éléments électrochimiques connectés en parallèle ;

f) mesure en temps réel de la température (T) de la batterie rechargeable ;

g) évaluation en temps réel d'une tension de contrôle (Vcontrol) égale à la somme de la valeur moyenne de la tension dans la zone plateau (E0_plateau) et du produit de la valeur de la résistance interne (Rcell) d'un élément électrochimique par la valeur du courant de charge maximal prédéterminé (IMR, IMR_C) autorisé en fonction de la température (T) mesurée ;

et dans le cas d'un contrôle en intensité :

e5) évaluation en temps réel de la tension maximale (Vmax) des éléments électrochimiques de la batterie définie comme étant le maximum des tensions mesurées (Vcell_n) aux bornes de chaque branche ;

e6) évaluation en temps réel d'un courant maximal seuil instantané de charge traversant les éléments électrochimiques connectés en parallèle en fonction de la tension de contrôle évaluée (Vcontrol) en régulant le courant maximal seuil instantané de charge de sorte que la tension maximale (Vmax) des éléments électrochimiques soit égale à la tension de contrôle évaluée (Vcontrol) ;

e7) détermination en temps réel d'un courant maximal instantané de charge (IMR_parallel ou IMR_C_parallel) à appliquer aux éléments électrochimiques, dans lequel le courant maximal instantané de charge est égal au minimum entre le courant maximal seuil instantané de charge évalué et le produit entre le nombre (p) d'éléments électrochimiques par branche et le courant de charge maximal prédéterminé (IMR, IMR_C) autorisé ; et

e8) transmission en temps réel à un régulateur de chargeur intégré dans la batterie de la valeur du courant maximal instantané de charge (IMR_parallel ou IMR_C_parallel) déterminée de manière à alimenter les éléments électrochimiques de la batterie avec une intensité inférieure ou égale au maximum de courant maximal instantané de charge déterminé ;

et dans le cas d'un contrôle en tension :

f) transmission en temps réel à un régulateur de chargeur intégré dans la batterie de la valeur de la tension de contrôle (Vcontrol) évaluée de manière à alimenter les éléments électrochimiques de la batterie.

2. Procédé de gestion de la charge selon la revendication 1, comprenant une étape de mesure de l'état de charge de chaque élément électrochimique (SOC) et/ou l'état de vieillissement de chaque élément électrochimique (SOH), et dans lequel on substitue l'étape de fourniture des données caractéristiques des éléments électrochimiques par une autre étape de fourniture de données caractéristiques des éléments électrochimiques comprenant au moins :

- une fonction prédéterminée représentant la variation de la valeur de la résistance interne (Rcell) d'un élément électrochimique de la batterie en fonction de la température (T) et de l'état de charge de chaque élément électrochimique (SOC) et/ou de l'état de vieillissement de chaque élément électrochimique (SOH),

- une valeur de courant de charge maximal prédéterminé (IMR, IMR_C) autorisé en fonction de la température (T) et de l'état de charge de chaque élément électrochimique (SOC) et/ou de l'état de vieillissement de chaque élément électrochimique (SOH), et

- la valeur de la tension dans la zone plateau (E0) en fonction de la température (T) et de l'état de charge de chaque élément électrochimique (SOC) et/ou de l'état de vieillissement de chaque élément électrochimique (SOH) ; et

dans lequel on substitue l'étape d'évaluation en temps réel de la tension de contrôle (Vcontrol) par une autre étape d'évaluation en temps réel de la tension de contrôle (Vcontrol) égale à la somme de la valeur moyenne de la tension dans la zone plateau (E0) et du produit de la valeur de la résistance interne (Rcell) d'un élément électrochimique par la valeur du courant de charge maximal prédéterminé (IMR, IMR_C) autorisé en fonction de la température (T) mesurée, et de l'état de charge de chaque élément électrochimique (SOC) mesuré et/ou de l'état de vieillissement de chaque élément électrochimique (SOH) mesuré.

3. Procédé de gestion de la charge selon l'une des revendications 1 ou 2, comprenant les étapes suivantes :

g1) fournir la valeur de la tension de fin de charge (Veoc) des éléments électrochimiques ;

g2) fournir un coefficient de fin de charge prédéterminé (Coef_eoc), le coefficient étant inférieur au nombre (p) d'éléments électrochimiques connectés en parallèle dans chaque branche ; et

et dans le cas d'un contrôle en intensité, avant l'étape e4) de transmission en temps réel à un régulateur de chargeur intégré dans la batterie de la valeur du courant maximal instantané de charge (IMR_parallel ou IMR_C_parallel) :

h1) après l'étape e3) de détermination en temps réel du courant maximal instantané de charge (IMR_parallel ou IMR_C_parallel) à appliquer aux éléments électrochimiques, on réalise une étape de détermination (S50) en temps réel d'un premier courant maximal instantané intermédiaire de charge égal au maximum entre le courant maximal seuil instantané de charge évalué et le produit du courant de charge maximal prédéterminé (IMR, IMR_C) autorisé par le coefficient de fin de charge (Coef_eoc) ;

h2) parallèlement aux étapes e), e3) et h1), on évalue (S52) en temps réel un second courant maximal instantané de charge intermédiaire en fonction de la valeur de la tension de fin de charge (Veoc), en régulant le second courant maximal seuil instantané de charge de sorte que la tension maximale (Vmax) des éléments électrochimiques soit égale à la tension de fin de charge (Veoc) ;

h3) détermination (S54) en temps réel d'un courant maximal instantané de charge (IMR_parallel ou IMR_C_parallel) à appliquer aux éléments électrochimiques, dans lequel le courant maximal instantané de charge est égal au minimum entre le premier et le second courant maximal instantané intermédiaire de charge évalués

et dans le cas d'un contrôle en tension, avant l'étape d d'évaluation en temps réel d'une tension de contrôle, on réalise les étapes suivantes :

i3) mise à jour (S72) d'une variable de fin de charge notée (Flag_eoc), initialement égale à zéro ; et
i4) tant que cette variable de fin de charge (Flag_eoc) vaut zéro, on réalise :

- l'étape d) d'évaluation en temps réel d'une tension de contrôle ; et
- si la valeur du courant instantanée de la batterie est supérieure au produit du coefficient de fin de charge (Coef_eoc) par la valeur du courant de charge maximal autorisé prédéterminé (IMR, IMR_C), on transmet en temps réel à un régulateur de chargeur intégré dans la batterie la valeur de la tension de contrôle (Vcontrol, Vcontrol_C) évaluée à l'étape d) de manière à alimenter les éléments électrochimiques de la batterie ;

i5) si cette variable de fin de charge (Flag_eoc) vaut un ou si la valeur du courant instantanée de la batterie est inférieure ou égale au produit du coefficient de fin de charge (Coef_eoc) par la valeur du courant de charge maximal autorisé prédéterminé (IMR, IMR_C), on réalise une étape (S74) d'évaluation d'une seconde tension de contrôle, en régulant le courant maximal prédéterminé de charge autorisé instantané de sorte que la valeur du courant instantanée de la batterie soit égale au produit du coefficient de fin de charge Coef_eoc par la valeur du courant de charge maximal autorisé prédéterminé (IMR, IMR_C) ; et

- si cette seconde tension de contrôle évaluée est inférieure à la tension de fin de charge (Veoc), on transmet en temps réel à un régulateur de chargeur intégré dans la batterie la seconde tension de contrôle (Vcontrol, Vcontrol_C) évaluée de manière à alimenter les éléments électrochimiques de la batterie ;
- sinon on transmet en temps réel à un régulateur de chargeur intégré dans la batterie la tension de fin de charge (Veoc) de manière à alimenter les éléments électrochimiques de la batterie.

4. Procédé de gestion de la charge selon l'une des revendications 1 à 3, dans lequel les éléments électrochimiques sont adaptés à être chargés de manière continue ou pulsée.

5. Procédé de gestion de la charge selon la revendication 3 ou 4, dans lequel le coefficient de fin de charge (Coef_eoc) est égal à 1.

6. Procédé de gestion de la charge selon la revendication 3 ou 4, dans lequel le coefficient de fin de charge (Coef_eoc) est compris entre le tiers et la moitié du nombre d'éléments électrochimiques par branche.

7. Régulateur de charge de batterie comprenant une mémoire comprenant un programme qui met en oeuvre le procédé selon l'une quelconque des revendications 1 à 6, dans lequel le régulateur limite ou fournit des informations permettant de limiter le courant de charge (I) à la valeur déterminée du courant maximal instantané autorisé en charge (IMR, IMR_C).

8. Batterie rechargeable comprenant au moins deux branches connectées en série, chaque branche comportant au moins deux éléments électrochimiques connectés en parallèle et un régulateur de charge selon la revendication 7, chaque élément électrochimique présentant un profil de charge (PC) comportant au moins une zone plateau directement suivie par une zone pentue dans lequel la variation de la tension en fonction de l'état de charge dans la zone plateau est en moyenne au moins 10 fois moins rapide que la variation de la tension dans la zone pentue.

9. Batterie selon la revendication 8, dans laquelle chaque élément électrochimique est du type lithium-ion.

10. Batterie selon la revendication 8, dans laquelle chaque élément électrochimique est de type Lithium-ion comprenant au moins une matière active pour l'électrode positive choisie dans la liste consistant en :

- un composé de formule $Li_xMn_{1-y-z}M'_yM''_zPO_4$ où M' et M" sont choisis dans le groupe consistant en B, Mg, Al, Si, Ca, Ti, V, Cr, Fe, Co, Ni, Cu, Zn, Y, Zr, Nb et Mo, et dans lequel M' et M" sont différents l'un de l'autre, $0,8 \leq x \leq 1,2$, $0 \leq y \leq 0,6$ et $0 \leq z \leq 0,2$ ; et
- un composé de formule $Li_xFe_{1-y}M_yPO_4$, où M est choisi dans le groupe consistant en B, Mg, Al, Si, Ca, Ti, V, Cr, Mn, Co, Ni, Cu, Zn, Y, Zr, Nb et Mo, et dans lequel $0,8 \leq x \leq 1,2$ et $0 \leq y \leq 0,6$.

11. Batterie selon la revendication 8, dans laquelle chaque élément électrochimique est de type Lithium-ion dont l'électrode positive comprend :

a) un oxyde lithié comprenant de l'aluminium et des métaux de transition contenant au moins du nickel et du cobalt ; et
b) un phosphate lithié d'au moins un métal de transition ;

et dont la surface de l'électrode positive est recouverte au moins partiellement d'une couche de carbone ; et
et dans laquelle la proportion massique de l'oxyde lithié de métaux de transition contenant au moins du nickel, du cobalt et de l'aluminium est inférieure ou égale à 10 % du poids de la composition ;
et dans laquelle la proportion massique du phosphate lithié d'au moins un métal de transition étant supérieure ou égale à 90% du poids de la composition.

12. Produit de programme d'ordinateur comprenant au moins une séquence d'instructions stockées et accessibles à un processeur, où l'exécution du processeur conduit à la mise en oeuvre des étapes de l'une quelconque des revendications 1 à 6.

13. Support d'information lisible par un ordinateur, permettant de mettre en oeuvre au moins une des séquences d'instructions du produit de programme d'ordinateur de la revendication 12.

**Patentansprüche**

1. Verfahren zur Verwaltung der Ladung eines Akkus durch eine Spannungskontrolle oder durch eine Stromstärkekontrolle, die eine Vielzahl (n) von in Reihe geschalteten Abzweigungen umfasst, wobei jede Abzweigung eine Vielzahl (p) von parallel geschalteten elektrochemischen Elementen umfasst, wobei jedes elektrochemische Element ein Ladeprofil (PC) aufweist, welches mindestens eine flache Zone umfasst, der direkt eine steile Zone folgt, wobei die Spannungsvariation in Abhängigkeit vom Ladezustand in der flachen Zone im Durchschnitt mindestens 10-mal langsamer erfolgt als die Variation der Spannung in der steilen Zone, wobei das Verfahren die folgenden Schritte umfasst:

a) Bereitstellung von Kenndaten der elektrochemischen Elemente, wobei die Kenndaten mindestens Folgendes umfassen:

* eine vorbestimmte Funktion, die die Variation des inneren Widerstandswerts (Rcell) eines elektrochemischen Elements des Akkus in Abhängigkeit von der Temperatur (T) darstellt,
* einen Wert eines vorbestimmen maximalen Ladestroms für ein Element (IMR, IMR_C), der in Abhängigkeit von der Temperatur (T) gestattet ist, und
* den Mittelwert der Spannung in der flachen Zone (E0_plateau),

e) Echtzeit-Messung der Spannung (Vcell_n) an den Klemmen jeder Abzweigung von parallel geschalteten elektrochemischen Elementen;
f) Echtzeitmessung der Temperatur (T) des Akkus;
g) Echtzeitbewertung einer Prüfspannung (Vcontrol) gleich der Summe des Mittelwerts der Spannung in der flachen Zone (E0_plateau) und des Produktes des inneren Widerstandswerts (Rcell) eines elektrochemischen Elements durch den Wert des vorbestimmten maximalen Ladestroms (IMR, IMR_C), der in Abhängigkeit von der gemessenen Temperatur (T) gestattet ist;
und im Falle einer Kontrolle der Stromstärke:

e5) Echtzeitbewertung der Maximalspannung (Vmax) der elektrochemischen Elemente des Akkus, die als das Maximum der an den Klemmen jeder Abzweigung gemessenen Spannungen (Vcell_n) definiert ist;

e6) Echtzeitbewertung eines momentanen maximalen Schwellen-Ladestroms, der durch die parallel geschalteten elektrochemischen Elemente strömt, in Abhängigkeit von der bewerteten Prüfspannung (Vcontrol) durch derartige Regelung des momentanen maximalen Schwellen-Ladestroms, dass die maximale Spannung (Vmax) der elektrochemischen Elemente gleich der bewerteten Prüfspannung (Vcontrol) ist;

e7) Echtzeitbestimmung eines momentanen maximalen Ladestroms (IMR_parallel oder IMR_C_parallel), der an die elektrochemischen Elemente anzulegen ist, wobei der momentane maximale Ladestrom gleich dem Minimum zwischen dem bewerteten momentanen maximalen Ladestrom und dem Produkt zwischen der Anzahl (p) von elektrochemischen Elementen pro Abzweigung und dem gestatteten vorbestimmten maximalen Ladestrom (IMR, IMR_C) ist; und

e8) Echtzeitübertragung an einen in den Akku integrierten Laderegler des Werts des bestimmten momentanen maximalen Ladestroms (IMR_parallel oder IMR_C_parallel), um die elektrochemischen Elemente des Akkus mit einer Stromstärke, die kleiner oder gleich dem Maximum eines bestimmten momentanen maximalen Ladestroms ist, zu versorgen;
und im Falle einer Spannungskontrolle:

f) Echtzeitübertragung des bewerteten der Prüfspannungwerts (Vcontrol) an einen in den Akku integrierten Laderegler, um damit die elektrochemischen Elemente des Akkus zu versorgen.

2. Verfahren zur Verwaltung der Ladung gemäß Anspruch 1, das einen Schritt des Messens des Ladezustands eines jeden elektrochemischen Elements (SOC) und/oder des Alterungszustands eines jeden elektrochemischen Elements (SOH) umfasst, und bei dem der Schritt der Bereitstellung der Kenndaten der elektrochemischen Elemente durch einen anderen Schritt der Bereitstellung von Kenndaten der elektrochemischen Elemente ersetzt wird, was mindestens Folgendes umfasst:

- eine vorbestimmte Funktion, die die Variation des inneren Widerstandswerts (Rcell) eines elektrochemischen Elements des Akkus in Abhängigkeit von der Temperatur (T) und dem Ladezustand eines jeden elektrochemischen Elements (SOC) und/oder dem Alterungszustand eines jeden elektrochemischen Elements (SOH) darstellt,

- einen Wert eines vorbestimmten maximalen Ladestroms (IMR, IMR C), der in Abhängigkeit von der Temperatur (T) und dem Ladezustand eines jeden elektrochemischen Elements (SOC) und/oder dem Alterungszustand eines jeden elektrochemischen Elements (SOH) gestattet ist, und

- den Wert der Spannung in der flachen Zone (E0) in Abhängigkeit von der Temperatur (T) und dem Ladezustand eines jeden elektrochemischen Elements (SOC) und/oder dem Alterungszustand eines jeden elektrochemischen Elements (SOH); und

bei welchem man den Schritt der Echtzeitbewertung der Prüfspannung (Vcontrol) durch einen anderen Schritt der Echtzeitbewertung der Prüfspannung (Vcontrol) ersetzt, die gleich der Summe des Durchschnittswerts der Spannung in der flachen Zone (E0) und des Produktes des inneren Widerstandswerts (Rcell) eines elektrochemischen Elements mit dem Wert des, in Abhängigkeit von der gemessenen Temperatur (T) gestatteten, vorbestimmten maximalen Ladestroms (IMR, IMR_C), und dem gemessenen Ladezustands eines jeden elektrochemischen Elements (SOC) und/oder dem gemessenen Alterungszustand eines jeden elektrochemischen Elements (SOH) ist.

3. Verfahren zur Verwaltung der Ladung gemäß einem der Ansprüche 1 oder 2, welches die folgenden Schritte umfasst:

g1) Bereitstellung des Werts der Ladeschlussspannung (Veoc) der elektrochemischen Elemente;

g2) Bereitstellung eines vorbestimmten Ladeend-Koeffizienten (Coef_eoc), wobei der Koeffizient kleiner als die Anzahl (p) von parallel geschalteten elektrochemischen Elementen in jeder Abzweigung ist; und

im Falle einer Stromstärkekontrolle vor dem Schritt e4) einer Echtzeitübertragung an einen in den Akku integrierten Laderegler des Werts des momentanen maximalen Ladestroms (IMR_parallel oder IMR_C-parallel):

h1) nach dem Schritt e3) der Echtzeitbestimmung des momentanen maximalen Ladestroms (IMR_parallel oder IMR_C_parallel), der an die elektrochemischen Elemente anzulegen ist, wird ein Schritt der Echtzeitbestimmung (S50) eines ersten momentanen maximalen Zwischen-Ladestroms gleich dem Maximum zwischen dem bewerteten momentanen maximalen Schwellen-Ladestroms und dem Produkt des, vom Ladeschlusskoeffizienten (Coef_eoc) gestatteten, vorbestimmten maximalen Ladestroms (IMR, IMR_C) durchgeführt;

h2) parallel zu den Schritten e), e3) und h1) wird die Echtzeitbewertung (S52) eines zweiten momentanen maximalen Zwischen-Ladestroms in Abhängigkeit von dem Wert der Ladeschlussspannung (Veoc) durchgeführt, wobei der zweite momentane maximale Schwellen-Ladestrom so geregelt ist, dass die maximale Spannung (Vmax) der elektrochemischen Elemente gleich der Ladeschlussspannung (Veoc) ist;

h3) Echtzeitbestimmung (S54) eines momentanen maximalen Ladestroms (IMR_parallel oder IMR_C_parallel), der an die elektrochemischen Elemente anzulegen ist, wobei der momentane maximale Ladestrom gleich dem Minimum zwischen dem ersten und dem zweiten bewerteten momentanen maximalen Zwischen-Ladestrom ist,

und im Falle einer Spannungskontrolle vor dem Schritt der Echtzeitbewertung einer Prüfspannung werden die folgenden Schritte durchgeführt:

i3) Aktualisierung (S72) einer zur Kenntnis genommenen Ladeschlussvariablen (Flag_eoc), die ursprünglich gleich Null ist; und

i4) solange die Ladeschlussvariable (Flag_eoc) gleich Null ist, wird Folgendes durchgeführt:

- der Schritt d) der Echtzeitbewertung einer Prüfspannung; und
- wenn der momentane Stromwert des Akkus mit dem Wert des gestatteten, vorbestimmten maximalen Ladestroms (IMR, IMR_C) größer ist als das Produkt des Ladeschlusskoeffizienten (Coef_eoc), dann wird in Echtzeit an einen in den Akku integrierten Laderegler der Wert, der in Schritt d) bewerteten Prüfspannung (Vcontrol, Vcontrol_C) übertragen, um so die elektrochemischen Elemente des Akkus zu versorgen;

i5) wenn diese Ladeschlussvariable (Flag eoc) gleich eins ist, oder wenn der momentane Stromwert des Akkus kleiner oder gleich dem Produkt des Ladeschlusskoeffizienten (Coef eoc) mit dem Wert des vorbestimmten maximal gestatteten Ladestromwerts (IMR, IMR_C) ist, wird ein Schritt (S74) der Bewertung einer zweiten Prüfspannung durchgeführt, wobei der gestattete, maximale vorbestimmte momentane Ladestrom so geregelt ist, dass der momentane Stromwert des Akkus gleich dem Produkt des Ladeschlusskoeffizienten Coef_eoc mit dem Wert des vorbestimmten maximal gestatteten Ladestroms (IMR, IMR_C) ist; und

- wenn diese zweite bewertete Prüfspannung kleiner als die Ladeschlussspannung (Veoc) ist, wird in Echtzeit an einen in den Akku integrierten Laderegler die zweite bewertete Prüfspannung (Vcontrol, Vcontrol_C) übertragen, um die elektrochemischen Elemente des Akkus zu versorgen;
- andernfalls wird in Echtzeit an einen in den Akku integrierten Laderegler die Ladeschlussspannung (Veoc) übertragen, um die elektrochemischen Elemente des Akkus zu versorgen.

4. Verfahren zur Verwaltung der Ladung gemäß einem der Ansprüche 1 bis 3, bei dem die elektrochemischen Elemente eingerichtet sind, um kontinuierlich oder impulsartig geladen zu werden.

5. Verfahren zur Verwaltung der Ladung gemäß Anspruch 3 oder 4, bei dem der Ladeschlusskoeffizient (Coef_eoc) gleich 1 ist.

6. Verfahren zur Verwaltung der Ladung gemäß Anspruch 3 oder 4, bei dem der Ladeschlusskoeffizient (Coef_eoc) zwischen einem Drittel und der Hälfte der Anzahl von elektrochemischen Elementen pro Abzweigung liegt.

7. Laderegler eines Akkus, welcher einen Speicher umfasst, der ein Programm umfasst, das das Verfahren gemäß einem der Ansprüche 1 bis 6 durchführt, wobei der Regler den Ladestrom (I) auf den bestimmten Wert des maximal gestatteten momentanen Ladestroms (IMR, IMR_C) begrenzt oder Informationen liefert, die es ermöglichen, diesen zu begrenzen.

8. Akku, welcher mindestens zwei in Reihe geschaltete Abzweigungen umfasst, wobei jede Abzweigung mindestens zwei parallel geschaltete elektrochemische Elemente und einen Laderegler gemäß Anspruch 7 umfasst, wobei jedes elektrochemische Element ein Ladeprofil (PC) aufweist, welches mindestens eine flache Zone umfasst, auf die direkt eine steile Zone folgt, in der die Variation der Spannung in Abhängigkeit vom Ladezustand der flachen Zone im Durchschnitt mindestens 10-mal langsamer ist als die Variation der Spannung in der steilen Zone.

9.  Akku gemäß Anspruch 8, bei dem jedes elektrochemische Element vom Lithium-Ionen-Typ ist.

10. Akku gemäß Anspruch 8, bei dem jedes elektrochemische Element vom Lithium-Ionen-Typ ist, das mindestens einen, in der folgenden Liste ausgewählten, Aktivstoff für die positive Elektrode umfasst, der aus Folgendem besteht:

   - eine Verbindung der Formel $Li_xMn_{1-y-z}M'_yM''_zPO_4$, wo M' und M" in der Gruppe ausgewählt sind, die aus B, Mg, Al, Si, Ca, Ti, V, Cr, Fe, Co, Ni, Cu, Zn, Y, Zr, Nb und Mo, besteht, und wo M' und M" voneinander unterschiedlich sind, und bei $0{,}8 \leq x \leq 1{,}2$, $0 \leq y \leq 0{,}6$ und $0 \leq z \leq 0{,}2$ liegen; und
   - eine Verbindung der Formel $Li_xFe_{1-y}M_yPO_4$, wobei M in der Gruppe ausgewählt ist, die aus B, Mg, Al, Si, Ca, Ti, V, Cr, Mn, Co, Ni, Cu, Zn, Y, Zr, Nb und Mo, besteht, und wobei $0{,}8 \leq x \leq 1{,}2$ und bei $0 \leq y \leq 0{,}6$ **liegen.**

11. Akku gemäß Anspruch 8, bei dem jedes elektrochemische Element vom Lithium-Ionen-Typ ist, dessen positive Elektrode Folgendes umfasst:

   a) ein Lithium enthaltendes Oxid, welches Aluminium und Übergangsmetalle umfasst, die mindestens Nickel und Kobalt enthalten; und
   b) ein Lithium enthaltendes Phosphat von mindestens einem Übergangsmetall;

   und bei dem die Oberfläche der positiven Elektrode zumindest teilweise mit einer Kohlenstoffschicht überzogen ist; und
   bei dem der Massenanteil des Lithium enthaltenden Oxids von Übergangsmetallen die mindestens Nickel, Kobalt und Aluminium enthalten, kleiner oder gleich 10% des Gewichts der Zusammensetzung ist;
   und bei dem der Massenanteil des Lithium enthaltenden Phosphats von mindestens einem Übergangsmetall; größer oder gleich 90% des Gewichts der Zusammensetzung ist.

12. Computerprogrammprodukt, welches mindestens eine Sequenz von Befehlen umfasst, die gespeichert und für einen Prozessor zugänglich sind, wobei die Prozessorausführung zur Durchführung der Schritte irgendeines der Ansprüche 1 bis 6 führt.

13. Von einem Computer lesbarer Datenträger, der die Durchführung von mindestens einer der Befehlssequenzen des Computerprogrammprodukts aus Anspruch 12 ermöglicht.


**Claims**

1.  Method for managing the charging of a rechargeable battery using a voltage control or using current strength control comprising a plurality (n) of branches connected in series, each branch comprising a plurality (p) of electrochemical cells connected in parallel, each electrochemical cell having a charging profile (CP) comprising at least one plateau zone directly followed by a sloping zone in which the voltage variation as a function of the state of charge in the plateau zone is on average at least 10 times slower than the voltage variation in the sloping zone, said method comprising the following steps:

   a) providing characteristic data of the electrochemical cells, the characteristic data comprising at least:

   • a predetermined function representing the variation in the value of the internal resistance (Rcell) of an electrochemical cell of the battery as a function of the temperature (T),
   • a value of predetermined maximum charging current for an cell (IMR, IMR_C) allowed as a function of the temperature (T), and
   • the mean value of the voltage in the plateau zone (E0_plateau),

   b) real-time measurement of the voltage (Vcell_n) at the terminals of each branch of electrochemical cells connected in parallel;
   c) real-time measurement of the temperature (T) of the rechargeable battery;
   d) real-time evaluation of a control voltage (Vcontrol) equal to the sum of the mean value of the voltage in the plateau zone (E0_plateau) and the product of the value of the internal resistance (Rcell) of an electrochemical cell and the value of the predetermined maximum charging current (IMR, IMR_C) allowed as a function of the measured temperature (T);

and in the case of current strength control:

e1) real-time evaluation of the maximum voltage (Vmax) of the electrochemical cells of the battery defined as being the maximum of the measured voltages (Vcell_n) at the terminals of each branch;

e2) real-time evaluation of a threshold maximum instantaneous charging current passing through the electrochemical cells connected in parallel as a function of the evaluated control voltage (Vcontrol), by regulating the threshold maximum instantaneous charging current so that the maximum voltage (Vmax) of the electrochemical cells is equal to the evaluated control voltage (Vcontrol);

e3) real-time determination of a maximum instantaneous charging current (IMR_parallel or IMR_C_parallel) to be applied to the electrochemical cells, in which the maximum instantaneous charging current is equal to the minimum between the evaluated threshold maximum instantaneous charging current and the product of the number (p) of electrochemical cells per branch and the predetermined maximum allowed charging current (IMR, IMR_C); and

e4) real-time transmission of the value of the determined maximum instantaneous charging current (IMR_parallel or IMR_C_parallel) to a charger regulator integrated in the battery so as to power the electrochemical cells of the battery with a current strength less than or equal to the maximum of the determined maximum instantaneous charging current;

and in the case of a voltage control:

f) real-time transmission of the value of the evaluated control voltage (Vcontrol) to a charger regulator integrated in the battery so as to power the electrochemical cells of the battery.

2. Method for managing charging according to claim 1, comprising a step of measurement of the state of charge of each electrochemical cell (SOC) and/or the ageing state of each electrochemical cell (SOH), and in which the step of providing the characteristic data of the electrochemical cells is replaced with another step of providing characteristic data of the electrochemical cells comprising at least:

- a predetermined function representing the variation in the value of the internal resistance (Rcell) of an electrochemical cell of the battery as a function of the temperature (T) and the state of charge of each electrochemical cell (SOC) and/or the ageing state of each electrochemical cell (SOH),
- a value of predetermined maximum charging current (IMR, IMR_C) allowed as a function of the temperature (T) and the state of charge of each electrochemical cell (SOC) and/or the ageing state of each electrochemical cell (SOH), and
- the value of the voltage in the plateau zone (E0) as a function of the temperature (T) and the state of charge of each electrochemical cell (SOC) and/or the ageing state of each electrochemical cell (SOH); and

in which the step of real-time evaluation of the control voltage (Vcontrol) is replaced with another step of real-time evaluation of the control voltage (Vcontrol) equal to the sum of the mean value of the voltage in the plateau zone (E0) and the product of the value of the internal resistance (Rcell) of an electrochemical cell and the value of the predetermined maximum charging current (IMR, IMR_C) allowed as a function of the measured temperature (T), and the measured state of charge of each electrochemical cell (SOC) and/or the measured ageing state of each electrochemical cell (SOH).

3. Method for managing charging according to one of claims 1 or 2, comprising the following steps:

g1) providing the value of the end of charge voltage (Veoc) of the electrochemical cells;
g2) providing a predetermined end of charge coefficient (Coef_eoc), the coefficient being less than the number (p) of electrochemical cells connected in parallel in each branch; and

in the case of a current strength control, before the step e4) of real-time transmission of the value of the maximum instantaneous charging current (IMR_parallel or IMR_C_parallel) to a charger regulator integrated in the battery:

h1) after the step e3) of real-time determination of the maximum instantaneous charging current (IMR_parallel or IMR_C_parallel) to be applied to the electrochemical cells, a step of real-time determination (S50) of a first intermediate maximum instantaneous charging current equal to the maximum between the evaluated threshold maximum instantaneous charging current and the product of the predetermined maximum allowed charging current (IMR, IMR_C) and the end of charge coefficient (Coef_eoc) is carried out;

h2) in parallel with steps e), e3) and h1), a second intermediate maximum instantaneous charging current is evaluated (S52) in real time as a function of the value of the end of charge voltage (Veoc), by regulating the second threshold maximum instantaneous charging current so that the maximum voltage (Vmax) of the electrochemical cells is equal to the end of charge voltage (Veoc);

h3) real-time determination (S54) of a maximum instantaneous charging current (IMR_parallel or IMR_C_parallel) to be applied to the electrochemical cells, in which the maximum instantaneous charging current is equal to the minimum between the evaluated first and second intermediate maximum instantaneous charging currents;

and in the case of a voltage control, before the step d of real-time evaluation of a control voltage, the following steps are carried out:

i3) updating (S72) of a recorded end of charge variable (Flag_eoc), initially equal to zero; and
i4) for as long as this end of charge variable (Flag_eoc) equals zero, the following are carried out:

- the step d) of real-time evaluation of a control voltage; and
- if the value of the instantaneous current of the battery is greater than the product of the end of charge coefficient (Coef_eoc) and the value of the predetermined maximum allowed charging current (IMR, IMR_C), the value of the control voltage (Vcontrol, Vcontrol_C) evaluated in step d) is transmitted in real time to a charger regulator integrated in the battery so as to power the electrochemical cells of the battery;

i5) if this end of charge variable (Flag_eoc) equals one or if the value of the instantaneous current of the battery is less than or equal to the product of the end of charge coefficient (Coef_eoc) and the value of the predetermined maximum allowed charging current (IMR, IMR_C), a step (S74) of evaluation of a second control voltage is carried out, by regulating the predetermined maximum allowed instantaneous charging current so that the value of the instantaneous current of the battery is equal to the product of the end of charge coefficient Coef_eoc and the value of the predetermined maximum allowed charging current (IMR, IMR_C); and

- if this evaluated second control voltage is less than the end of charge voltage (Veoc), the evaluated second control voltage (Vcontrol, Vcontrol_C) is transmitted in real time to a charger regulator integrated in the battery so as to power the electrochemical cells of the battery;
- otherwise the end of charge voltage (Veoc) is transmitted in real time to a charger regulator integrated in the battery so as to power the electrochemical cells of the battery.

4. Method for managing charging according to one of claims 1 to 3, in which the electrochemical cells are suitable for continuous or pulsed charging.

5. Method for managing charging according to claim 3 or 4, in which the end of charge coefficient (Coef_eoc) is equal to 1.

6. Method for managing charging according to claim 3 or 4, in which the end of charge coefficient (Coef_eoc) is comprised between a third and half of the number of electrochemical cells per branch.

7. Battery charging regulator comprising a memory comprising a program which implements the method according to any one of claims 1 to 6, in which the regulator limits, or provides information making it possible to limit, the charging current (I) to the determined value of the maximum allowed instantaneous charging current (IMR, IMR_C).

8. Rechargeable battery comprising at least two branches connected in series, each branch comprising at least two electrochemical cells connected in parallel and a charging regulator according to claim 7, each electrochemical cell having a charging profile (CP) comprising at least one plateau zone directly followed by a sloping zone in which the voltage variation as a function of the state of charge in the plateau zone is on average at least 10 times slower than the voltage variation in the sloping zone.

9. Battery according to claim 8, in which each electrochemical cell is of the lithium-ion type.

10. Battery according to claim 8, in which each electrochemical cell is of the lithium-ion type comprising at least one active substance for the positive electrode chosen from the list consisting of:

- a compound with the formula $Li_xMn_{1-y-z}M'_yM''_zPO_4$ where M' and M'' are chosen from the group consisting of B, Mg, Al, Si, Ca, Ti, V, Cr, Fe, Co, Ni, Cu, Zn, Y, Zr, Nb and Mo, and in which M' and M" are different from each other, $0.8 \leq x \leq 1.2$, $0 \leq y \leq 0.6$ and $0 \leq z \leq 0.2$; and
- a compound with the formula $Li_xFe_{1-y}M_yPO_4$ where M is chosen from the group consisting of B, Mg, Al, Si, Ca, Ti, V, Cr, Mn, Co, Ni, Cu, Zn, Y, Zr, Nb and Mo, and in which $0.8 \leq x \leq 1.2$ and $0 \leq y \leq 0.6$.

11. Battery according to claim 8, in which each electrochemical cell is of the lithium-ion type the positive electrode of which comprises:

   a) a lithium-containing oxide comprising aluminium and transition metals containing at least nickel and cobalt; and
   b) a lithium-containing phosphate of at least one transition metal;

   and the surface of the positive electrode of which is at least partially covered with a layer of carbon; and
   in which the proportion by mass of the lithium-containing oxide of transition metals containing at least nickel, cobalt and aluminium is less than or equal to 10% of the weight of the composition;
   and in which the proportion by mass of the lithium-containing phosphate of at least one transition metal is greater than or equal to 90% of the weight of the composition.

12. Computer program product comprising at least one sequence of instructions stored on and accessible to a processor, where execution by the processor leads to the implementation of the steps of any one of claims 1 to 6.

13. Computer-readable data medium, making it possible to implement at least one of the sequences of instructions of the computer program product of claim 12.

## Figure 1

## Figure 2

**Figure 3**

Gestion des courants continus en charge

$Vcontrol\_C(t+Dtime) = Eo+Rcell(t+Dtime)*IMR\_C(t+Dtime)$ ⟶ S12

Regulation sur IMR_C_Parallel pour obtenir Vmax=Vcontrol_C
$IMR\_C\_Parallel(t+Dtime) = min(IMR\_C\_Parallel(t+Dtime);p*IMR\_C(t+Dtime))$ ⟶ S14

IMR_C_Parallel(t+Dtime) ⟶ S16

Système de gestion batterie

# Figure 4

Gestion des courants pulse en charge

$Vcontrol(t+Dtime) = Eo+Rcell(t+Dtime)*IMR(t+Dtime)$ ⟶ S22

Regulation sur IMR_Parallel pour obtenir Vmax=Vcontrol
$IMR\_Parallel(t+Dtime) = min(IMR\_Parallel(t+Dtime); p*IMR(t+Dtime))$ ⟶ S24

IMR_Parallel(t+Dtime)
S26

Système de gestion batterie

# Figure 5

Gestion des courants continus en charge

Vcontrol_C(t+Dtime) = Eo_plateau+Rcell(t+Dtime)*IMR_C(t+Dtime)

Système de gestion batterie

# Figure 6

Gestion des courants pulses en charge

Vcontrol(t+Dtime) = Eo_plateau+Rcell(t+Dtime)*IMR(t+Dtime)

Système de gestion batterie

# Figure 7

Gestion des courants continus en charge

Vcontrol_C(t+Dtime) =
Eo(SOC,T)+Rcell(SOC,T)(t+Dtime)*IMR_C(SOC,T)(t+Dtime)

— S32

Regulation sur IMR_C_Parallel pour obtenir Vmax=Vcontrol_C
IMR_C_Parallel(t+Dtime) = min(IMR_C_Parallel(t+Dtime); p*IMR_C(SOC,T)(t+Dtime))

— S34

IMR_C_Parallel(t+Dtime)

— S36

Système de gestion batterie

# Figure 8

Gestion des courants pulse en charge

Vcontrol(t+Dtime) = Eo (SOC,T)+Rcell(SOC,T)(t+Dtime)*IMR(SOC,T)(t+Dtime)

— S42

Regulation sur IMR_Parallel pour obtenir Vmax=Vcontrol
IMR_Parallel(t+Dtime) = min(IMR_Parallel(t+Dtime); p*IMR(SOC,T)(t+Dtime))

— S44

IMR_Parallel(t+Dtime)

— S46

Système de gestion batterie

# Figure 9

Call every Dtime

Gestion des courants de charge continus

Vcontrol_C(t+Dtime) = Eo_plateau+Rcell(t+Dtime)*IMR_C(t+Dtime) — S12

Regulation sur IMR_C_Parallel pour obtenir Vmax=Vcontrol_C
IMR_C_Parallel(t+Dtime) = min(IMR_C_Parallel(t+Dtime);p*IMR_C(t+Dtime)) — S14

IMR_C_Parallel(t+Dtime) = max (IMR_C_Parallel(t+Dtime) ; IMR_C(t+Dtime)*Coef_eoc) — S50

Regulation sur IMR_C_Parallel_eoc pour obtenir Vmax=Veoc — S52

IMR_C_Parallel(t+Dtime)=min( IMR_C_Paralle(t+Dtime); IMR_C_Parallel_eoc(t+Dtime)) — S54

Système de gestion battery

# Figure 10

Figure 11

Gestion des courants pulse
de charge

Flag_eoc(t+Dtime)=Flag_eoc(t)  S72

Si Flag_eoc(t)=0

Vrai                    Faux

S14

Vcontrol(t+Dtime)
=Eo_plateau+Rcell(t+Dtime)*IMR(t+Dtime)

Si I(t+Dtime) > IMR(t+Dtime)*Coef_eoc

Vrai                    Faux

On garde la valeur Vcontrol(t+Dtime)
précédemment calculée

Regulation sur Vcontrol(t+Dtime) pour obtenir
I=IMR(t+Dtime)*Coef_eoc
Flag_eoc(t)=1  S74

Si Vcontrol(t+Dtime) >=Veoc

Faux

Vrai

Vcontrol(t+Dtime) = Veoc

Vcontrol(t+Dtime)

Système de gestion
batterie

# Figure 12

# Figure 13

# Figure 14

Figure 15

Figure 16

Figure 17

Figure 18

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- EP 2144075 A
- EP 2239826 A
- EP 2309615 A
- EP 2269954 A
- US 7940027 B
- US 6121752 A
- FR 1251925